# EUROPEAN PATENT APPLICATION

(11) **EP 3 041 046 A1**
(43) Date of publication of application: **06.07.2016**
(21) Application number: 14841323.0
(22) Date of filing: 25.08.2014
(51) Int. Cl.: H01L 23/13

(54) **MOUNTING SUBSTRATE WAFER, MULTILAYER CERAMIC SUBSTRATE, MOUNTING SUBSTRATE, CHIP MODULE, AND MOUNTING SUBSTRATE WAFER MANUFACTURING METHOD**

(30) Priority: 26.08.2013 JP 2013174377
(71) Applicant: Hitachi Metals, Ltd., Tokyo 1088224 (JP)
(72) Inventor: NAGATOMO Hiroyuki, Mishima-gun Osaka 618-0013 (JP); MASUKAWA Junichi, Mishima-gun Osaka 618-0013 (JP)
(74) Representative: Fleuchaus, Michael A.
(86) International application number: PCT/JP2014/072175
(87) International publication number: WO 2015/029951

(57) **Abstract**

A wafer for mounting substrates according to the present disclosure includes a multilayer ceramic substrate including top face electrodes, bottom face electrodes, and internal electrodes providing connection between the top face electrodes and the bottom face electrodes, and a wiring pattern formed on a top face of the multilayer ceramic substrate. The wiring pattern has a minimum line width which is equal to or less than 2 µm and a minimum line space which is equal to or less than 2 µ m. When the wafer for mounting substrates is zoned into a plurality of regions by the units of 20 mm x 20 mm, at least 50% of the regions satisfy the condition that an SFQR in 20 mm x 20 mm evaluation region be equal to or less than 2 µm, at the top face of the multilayer ceramic substrate.

## Description

### TECHNICAL FIELD

The present disclosure relates to a wafer for mounting substrates, a multilayer ceramic substrate, a mounting substrate, a chip module, and a method of producing a wafer for mounting substrates.

### BACKGROUND ART

As semiconductor integrated circuit devices (hereinafter referred to as "semiconductor chips") have improved in their degrees of integration, large differences have emerged between the semiconductor chip and the main substrate, in terms of the array pitch (inter-electrode-central distance) of electrode terminals on each. This has brought public attention to "interposers" which, when a semiconductor chip is to be mounted on a main substrate, act as an intermediary in the electrical connection between them.

Patent Document 1 discloses a wiring board for semiconductor chip mounting, which may function as an "interposer". This substrate for die mounting is made of a combination of a rigid substrate of glass epoxy that has one layer of wiring and a flexible substrate that has two layers of wiring. The wiring on the rigid substrate is structured so as to be capable of connecting to the narrow-pitched electrodes on a semiconductor chip. On the other hand, the wiring on the flexible substrate is structured so as to enable mounting on a main substrate (mother board).

Patent Document 2 discloses a wiring board with an internal silicon interposer, in which a first unit wiring board and a second unit wiring board that are made of a glass cloth epoxy resin are combined with a silicon substrate.

Patent Document 3 discloses a wiring board in which a silicon substrate having a fine line pattern and a multilayer ceramic substrate are combined. The multilayer ceramic substrate and the silicon substrate each include a plurality of internal electrodes that extend through the respective substrate.

Patent Document 4 discloses a ceramic polycrystalline substrate and a glass multilayer ceramic substrate with high smoothness.

### CITATION LIST

### PATENT LITERATURE

[Patent Document 1] Japanese Laid-Open Patent Publication No. 2000-353765
[Patent Document 2] Japanese Laid-Open Patent Publication No. 2008-166327
[Patent Document 3] Japanese Laid-Open Patent Publication No. 2011-155149
[Patent Document 4] The specification of Japanese Patent No. 4872306

### SUMMARY OF INVENTION

### TECHNICAL PROBLEM

Generally speaking, bump electrodes that are connected to a semiconductor chip have an array pitch of 50 *µ*m or less. On the other hand, electrodes to be mounted on a main substrate, e.g., a printed circuit board, have an array pitch of about 500 *µ* m to about 1 mm. In commercialized interposers, the wiring structure on the top face, on which a semiconductor chip with a high degree of integration is to be mounted, is formed on a silicon substrate. However, it is impossible to arrange pluralities of electrodes on the top face and the bottom face of a silicon substrate, these pluralities of electrodes having different inter-central distances, and connect them by way of internal electrodes. Therefore, in order to form electrode structures that enable mounting on a main substrate, an interposer having a silicon substrate requires some special structure, another substrate (a substrate made of a resin or ceramic), or the like.

An embodiment in the present disclosure is able to provide a wafer for mounting substrates, a multilayer ceramic substrate, a mounting substrate, a chip module, and a method of producing a wafer for mounting substrates, which can realize an interposer that does not include a silicon substrate.

### SOLUTION TO PROBLEM

A wafer for mounting substrates according to the present disclosure comprises: a multilayer ceramic substrate having a top face and a bottom face and including: a top-face ceramic layer located at the top face; a bottom-face ceramic layer located at the bottom face; a plurality of top face electrodes extending through the top-face ceramic layer, a plurality of bottom face electrodes extending through the bottom-face ceramic layer; and an intermediate ceramic layer having a plurality of internal electrodes formed therein, the plurality of internal electrodes being internal to the multilayer ceramic substrate and providing electrical connection between the plurality of top face electrodes and the plurality of bottom face electrodes; and a wiring pattern formed on the top face of the multilayer ceramic substrate, the wiring pattern having a minimum line width which is equal to or less than 2 *µ*m and a minimum line space which is equal to or less than 2 *µ*m, wherein, an inter-electrode-central distance of the plurality of top face electrodes is smaller than an inter-electrode-central distance of the plurality of bottom face electrodes; and the top face of the multilayer ceramic substrate, when zoned into a plurality of evaluation regions by the units of 20 mm x 20 mm, is planarized so that SFQR (Site Front Least Squares Ranges) in a 20 mm x 20 mm evaluation region is equal to or less than 2 *µ*m in at least 50% of the plurality of evaluation regions.

In one embodiment, the top face of the multilayer ceramic substrate, when zoned into a plurality of evaluation regions by the units of 20 mm x 20 mm, is planarized so that SBIR (Site Back Surface Referenced Ideal Ranges) in a 20 mm x 20 mm region is equal to or less than 2 *µ*m in at least 50% of the plurality of evaluation regions.

In one embodiment, the top face of the multilayer ceramic substrate is planarized so that GBIR (Global Back Ideal Ranges) is equal to or less than 2 *µ*m.

One embodiment comprises a dielectric layer between the top face of the multilayer ceramic substrate and the wiring pattern, wherein, the dielectric layer has a plurality of holes for electrically connecting each of the plurality of top face electrodes to the wiring pattern; and the plurality of top face electrodes are respectively aligned with the plurality of holes.

In one embodiment, a distance from a center position of each of the plurality of top face electrodes to a center position of a corresponding one of the plurality of holes is equal to or less than a radius of the top face electrode.

In one embodiment, positions of the plurality of holes are defined through a photolithography step.

In one embodiment, positions of the plurality of wiring patterns are defined through a photolithography step.

A multilayer ceramic substrate according to the present disclosure is a multilayer ceramic substrate for any of the above wafers for mounting substrates, the multilayer ceramic substrate having a top face and a bottom face, the multilayer ceramic substrate comprising: a top-face ceramic layer located at the top face; a bottom-face ceramic layer located at the bottom face; a plurality of top face electrodes extending through the top-face ceramic layer; a plurality of bottom face electrodes extending through the bottom-face ceramic layer; and an intermediate ceramic layer having a plurality of internal electrodes formed therein, the plurality of internal electrodes providing electrical connection between the plurality of top face electrodes and the plurality of bottom face electrodes, wherein, an inter-electrode-central distance of the plurality of top face electrodes is smaller than an inter-electrode-central distance of the plurality of bottom face electrodes; and the top face of the multilayer ceramic substrate, when zoned into a plurality of evaluation regions by the units of 20 mm x 20 mm, is planarized so that SFQR (Site Front Least Squares Ranges) in a 20 mm x 20 mm region is equal to or less than 2 *µ*m in at least 50% of the plurality of evaluation regions.

A mounting substrate according to the present disclosure is a mounting substrate for a semiconductor chip to be mounted thereon, comprising: a ceramic chip substrate including a top-face ceramic layer located at a top face, a bottom-face ceramic layer located at a bottom face, a plurality of top face electrodes extending through the top-face ceramic layer, a plurality of bottom face electrodes extending through the bottom-face ceramic layer, and an intermediate ceramic layer having a plurality of internal electrodes formed therein, the plurality of internal electrodes being internal to the multilayer ceramic substrate and providing electrical connection between the plurality of top face electrodes and the plurality of bottom face electrodes; and a wiring pattern formed on the top face of the ceramic chip substrate, the wiring pattern having a minimum line width which is equal to or less than 2 µm and a minimum line space which is equal to or less than 2 µm, wherein, an inter-electrode-central distance of the plurality of top face electrodes is smaller than an inter-electrode-central distance of the plurality of bottom face electrodes; and the top face of the ceramic chip substrate is planarized so that SFQR (Site Front Least Squares Ranges) in a 20 mm x 20 mm region is equal to or less than 2 *µ*m.

In one embodiment, the top face of the ceramic chip substrate is planarized so that SBIR (Site Back Surface Referenced Ideal Ranges) in a 20 mm x 20 mm region is equal to or less than 2 *µ*m.

One embodiment comprises a plurality of bump electrodes formed on the wiring pattern.

In one embodiment, an inter-electrode-central distance of the plurality of bump electrodes is 1/10 or less of the inter-electrode-central distance of the bottom face electrodes.

One embodiment comprises a dielectric layer between the top face of the ceramic chip substrate and the wiring pattern, wherein, the dielectric layer has a plurality of holes for electrically connecting each of the plurality of top face electrodes to the wiring pattern; and the plurality of top face electrodes are respectively aligned with the plurality of holes.

In one embodiment, a distance from a center position of each of the plurality of top face electrodes to a center position of a corresponding one of the plurality of holes is equal to or less than a radius of the top face electrode.

In one embodiment, positions of the plurality of holes are defined through a photolithography step.

In one embodiment, positions of the plurality of wiring patterns are defined through a photolithography step.

A chip module according to the present disclosure comprises: any of the above mounting substrates; and a plurality of semiconductor chips mounted on the mounting substrate.

A mounting substrate according to the present disclosure is a mounting substrate having been individually cut out from any of the above wafers for mounting substrates, comprising a plurality of bump electrodes formed on the wiring pattern.

In one embodiment, an inter-electrode-central distance of the plurality of bump electrodes is 1/10 or less of the inter-electrode-central distance of the bottom face electrodes.

A chip module according to the present disclosure comprises: any of the above mounting substrates; and a plurality of semiconductor chips mounted on the mounting substrate.

A method of producing a wafer for mounting substrates according to the present disclosure comprises: a step of providing a multilayer ceramic substrate including a top-face ceramic layer located at a top face, a bottom-face ceramic layer located at a bottom face, a plurality of top face electrodes extending through the top-face ceramic layer, a plurality of bottom face electrodes extending through the bottom-face ceramic layer, and an intermediate ceramic layer having a plurality of internal electrodes formed therein, the plurality of internal electrodes being internal to the multilayer ceramic substrate and providing electrical connection between the plurality of top face electrodes and the plurality of bottom face electrodes, wherein an inter-electrode-central distance of the plurality of top face electrodes is smaller than an inter-electrode-central distance of the plurality of bottom face electrodes; a step of applying a planarization process to at least the top face of the multilayer ceramic substrate so that, when the multilayer ceramic substrate is zoned into a plurality of evaluation regions by the units of 20 mm x 20 mm, SFQR (Site Front Least Squares Ranges) in a 20 mm x 20 mm evaluation region is equal to or less than 2 *µ*m in at least 50% of the plurality of evaluation regions; and a step of forming a wiring pattern on the top face of the multilayer ceramic substrate through photolithography, the wiring pattern having a minimum line width which is equal to or less than 2 *µ*m and a minimum line space which is equal to or less than 2 *µ*m; wherein, the step of providing the multilayer ceramic substrate comprises: a step of providing a first green sheet to compose the top-face ceramic layer and a second green sheet to compose the bottom-face ceramic layer; a step of subjecting the first and second green sheets to aging; a step of, after the aging treatment, forming a plurality of holes defining the plurality of top face electrodes and the plurality of bottom face electrodes in the first and second green sheets; a step of providing at least one third green sheet to compose at least one ceramic layer located between the top-face ceramic layer and the bottom-face ceramic layer; a step of forming a plurality of holes defining the plurality of internal electrodes in the third green sheet; a step of filling the plurality of holes of the first, second, and third green sheets with an electrically conductive material; a step of stacking and laminating the first, second, and third green sheets to form a laminated ceramic green sheet; and a step of firing the laminated ceramic green sheet to form a sintered ceramic body, the sintered ceramic body including internal electrodes to connect a top face and a bottom face, top face electrodes, and bottom face electrodes.

In one embodiment, before and after the step of firing the laminated ceramic green sheet, the multilayer ceramic substrate contracts by a distance of 1% or less along any in-plane direction.

A method of producing a wafer for mounting substrates according to the present disclosure comprises: a step of forming a plurality of electrode vias in a green sheet of a ceramic, and filling the electrode vias with an electrode paste from at least one face of the green sheet, to form a green sheet with electrodes; a step of stacking and laminating a plurality of said green sheets with electrodes so that the respective electrodes are electrically connected therebetween, thereby forming a laminated ceramic green sheet as an integral piece; a step of firing the laminated ceramic green sheet to form a sintered ceramic body, the sintered ceramic body including internal electrodes to connect a top face and a bottom face, top face electrodes, and bottom face electrodes; a step of obtaining a multilayer ceramic substrate by processing at least the top face of the sintered ceramic body, the multilayer ceramic substrate having a top face planarized so that, when zoned into a plurality of evaluation regions by the units of 20 mm x 20 mm, SFQR in a 20 mm x 20 mm evaluation region is equal to or less than 2 *µ* m in at least 50% of the plurality of evaluation regions; and a step of forming a wiring pattern through photolithography using an exposure apparatus, the wiring pattern being electrically connected with the electrodes on at least the top face of the multilayer ceramic substrate.

In one embodiment, the step of forming the wiring pattern comprises: a step of forming a dielectric layer at least on the top face, and forming at least one or more throughholes in a portion or portions of the dielectric layer for revealing an electrode or electrodes on the top face; a step of forming a metal seed layer on the dielectric layer and in the throughhole; a step of applying a photoresist on the metal seed layer; a step of subjecting the photoresist to exposure by using an exposure apparatus; a step of subjecting the photoresist having undergone exposure to development for partially removing the photoresist to obtain a photoresist pattern; a step of allowing a plating layer to deposit on the metal seed layer, through an electroplating technique, in a place of the photoresist pattern where the photoresist has been partially removed, to obtain a wiring pattern; a step of removing the photoresist pattern; and a step of removing the metal seed layer formed in any region other than the place where the plating layer has been allowed to deposit.

In one embodiment, the step of forming the wiring pattern comprises: a step of forming a dielectric layer at least on the top face, and forming at least one or more throughholes in a portion or portions of the dielectric layer for revealing an electrode or electrodes on the top face; a step of applying a photoresist on the dielectric layer and over the throughhole; a step of subjecting the photoresist to exposure by using an exposure apparatus; a step of subjecting the photoresist having undergone exposure to development for partially removing the photoresist to obtain a photoresist pattern; a step of forming a metal layer on the photoresist pattern, dielectric layer, and throughhole by a vacuum film deposition technique; and a step of removing the photoresist pattern to remove (lift-off) the metal deposited on the photoresist pattern, thereby obtaining a wiring pattern while leaving only the metal deposited on the dielectric layer and the throughhole.

In one embodiment, in the step of obtaining the multilayer ceramic substrate, a top-face ceramic layer and a bottom-face ceramic layer of the sintered ceramic body are subjected to a planarization process, one face at a time.

In one embodiment, in the step of obtaining the multilayer ceramic substrate, a top-face ceramic layer and a bottom-face ceramic layer of the sintered ceramic body are subjected to a planarization process, both faces simultaneously.

In one embodiment, the step of obtaining the multilayer ceramic substrate comprises a step of processing at least a top face of the top-face ceramic layer by utilizing CMP (Chemical Mechanical Polishing).

### ADVANTAGEOUS EFFECTS OF INVENTION

An embodiment in the present disclosure is able to provide a mounting substrate and a chip module that do not require a silicon interposer. Moreover, a wafer for mounting substrates, a multilayer ceramic substrate, and a method of producing a wafer for mounting substrates for use in the production of such a mounting substrate are provided.

### BRIEF DESCRIPTION OF DRAWINGS

[FIG. **1**] A cross-sectional view showing an example fundamental constitution of a mounting substrate according to the present disclosure.
[FIG. **2A**] A cross-sectional view showing an example constitution of a chip module according to the present disclosure.
[FIG. **2B**] A plan view showing an inter-central distance of top face electrodes according to the present disclosure.
[FIG. **2C**] A plan view showing an inter-central distance of bottom face electrodes according to the present disclosure.
[FIG. **3**] An upper plan view of a portion of a dielectric layer **5** having a plurality of holes **5a.**
[FIG. **4A**] An upper plan view showing how center positions of top face electrodes 7 may be shifted from target positions.
[FIG. **4B**] An upper plan view showing an instance where top face electrodes **7** and holes **5a** in the dielectric layer **5** are aligned.
[FIG. **5**] A flowchart showing a fundamental constitution of an illustrative production method for a wafer for mounting substrates.
[FIG. **6**] A schematic diagram showing exemplary cross sections of first and second green sheets.
[FIG. **7**] A schematic diagram showing an exemplary cross section of a third green sheet.
[FIG. 8] A schematic cross-sectional view showing a laminated ceramic green sheet in which a first green sheet **21a**, a second green sheet **21b,** and a third green sheet **21c** are stacked.
[FIG. **9**] A schematic cross-sectional view of a laminated ceramic green sheet after firing and a multilayer ceramic substrate after polishing.
[FIG. **10**] A graph showing examples of deviations of top face electrodes from their target positions, along in-plane directions on a multilayer ceramic substrate.
[FIG. **11**] A schematic upper plan view of a wafer for mounting substrates according to the present disclosure.
[FIG. **12**] An upper plan view schematically showing an example of a mounting substrate according to the present disclosure.
[FIG. **13**] A cross-sectional view schematically showing an example of a mounting substrate according to the present disclosure.
[FIG. **14**] A schematic cross-sectional view for explaining SFQR.
[FIG. **15**] A schematic cross-sectional view for explaining SBIR.
[FIG. **16**] A schematic cross-sectional view for explaining GBIR.
[FIG. **17**] A schematic cross-sectional view of a wafer for mounting substrates, having bump electrodes **13** provided thereon.
[FIG. **18**] A schematic cross-sectional view for explaining SORI.
[FIG. **19**] A schematic perspective view showing an exemplary method of forming electrode vias **16** in a green sheet **15,** according to a first embodiment of the present disclosure.
[FIG. **20**] A schematic perspective view showing an exemplary method of filling the electrode vias **16** with an electrode material **18.**
[FIG. **21**] A schematic perspective view showing an exemplary method of forming a laminated ceramic green sheet **22** from plural green sheets **21** with electrodes.
[FIG. **22**] A schematic perspective view showing an exemplary method of processing a sintered ceramic body **23.**
[FIG. **23**] (**a**) is a schematic perspective view showing a multilayer ceramic substrate having a dielectric layer **5** formed on a top face; and **(b)** is a schematic cross-sectional view of the multilayer ceramic substrate shown in **(a).**
[FIG. **24**] (**a**) is a schematic perspective view showing the multilayer ceramic substrate having throughholes **27** formed in the dielectric layer **5;** and **(b)** is a schematic cross-sectional view of the multilayer ceramic substrate shown in **(a).**
[FIG. **25**] **(**a**)** is a schematic perspective view showing the multilayer ceramic substrate, with a metal base film **28** and a photoresist **29** being consecutively provided over the dielectric layer **5** and the throughholes **27; (b)** is a schematic cross-sectional view of the multilayer ceramic substrate shown in (**a**); and **(c)** is a diagram showing enlarged a portion of a cross section of the multilayer ceramic substrate shown in **(b)**.
[FIG. **26**] **(a)** is a perspective view schematically showing the multilayer ceramic substrate after a photoresist pattern 30 has been formed; and (b) is a schematic cross-sectional view of the multilayer ceramic substrate shown in (**a**).
[FIG. 27] (**a**) is a schematic perspective view showing the multilayer ceramic substrate, with a plating layer **31** having deposited on the metal base film **28;** and **(b)** is a schematic cross-sectional view of the multilayer ceramic substrate shown in **(a)**.
[FIG. **28**] **(a)** is a schematic perspective view showing the multilayer ceramic substrate, from which the photoresist pattern **30** and the metal base film **28** have been removed; and **(b)** is a schematic cross-sectional view of the multilayer ceramic substrate shown in (**a**).
[FIG. **29**] (**a**) is a schematic perspective view showing the multilayer ceramic substrate, with a photoresist pattern for forming a wiring pattern **6** having been formed on the dielectric layer **5;** and **(b)** is a schematic cross-sectional view of the multilayer ceramic substrate shown in **(a)**.
[FIG. **30**] **(a)** is a schematic perspective view showing the multilayer ceramic substrate, with a metal layer **32** being formed on the photoresist pattern **30;** and **(b)** is a schematic cross-sectional view of the multilayer ceramic substrate shown in **(a).**
[FIG. **31**] **(a)** is a schematic perspective view showing the multilayer ceramic substrate, from which the metal layer **32** has been removed by lift-off; and **(b)** is a schematic cross-sectional view of the multilayer ceramic substrate shown in **(a).**
[FIG. **32**] A schematic cross-sectional view of a mounting substrate **4a** having a dielectric layer **5** between a top face **3x** of a multilayer ceramic substrate **3** and a wiring pattern **6.**
[FIG. **33**] A graph showing a relationship between defocus and resolution.
[FIG. **34**] Electron micrographs showing a wiring pattern **6** having pattern failures, where photograph **(b)** has a four times higher magnification than the magnification of photograph **(a).**
[FIG. **35**] Electron micrographs showing a wiring pattern **6** without a pattern failure, where photograph **(b)** has a four times higher magnification than the magnification of photograph **(a).**

### DESCRIPTION OF EMBODIMENTS

First, several terms which are used in the present specification and the claims will be described.

A "multilayer ceramic substrate" is a stack of plural ceramic layers, and is a constituent element of a "wafer for mounting substrates" which is described below. A "multilayer ceramic substrate" has a plate-like shape with a rectangular upper face, for example, but it may have been processed into a disk shape. The shape of a "multilayer ceramic substrate" is not limited to the examples in the embodiments which are described below.

A "wafer for mounting substrates" includes as constituent elements: a multilayer ceramic substrate; and a wiring pattern formed on a top face of the multilayer ceramic substrate. Although a wafer for mounting substrates typically has a generally disk shape, the shape of a wafer for mounting substrates is not limited to a disk.

The aforementioned multilayer ceramic substrate and wafer for mounting substrates are in a state before being split into a plurality of pieces.

A "mounting substrate" is a piece which has been cut out from a wafer for mounting substrates, as resulting from splitting the wafer for mounting substrates into a plurality of pieces. A mounting substrate includes, as its base, a piece of the multilayer ceramic substrate that was included in the wafer for mounting substrates. This piece is referred to as a "ceramic chip substrate", as opposed to the "multilayer ceramic substrate" existing before being split. The "ceramic chip substrate" might also be referred to as a "singulated multilayer ceramic substrate".

A "chip module" includes as constituent elements: a mounting substrate; and a semiconductor chip(s) mounted on the mounting substrate.

Note that, since a mounting substrate is a piece which has been singulated from a wafer for mounting substrates, the structure of the ceramic chip substrate that is included in the mounting substrate is identical to a local structure of the multilayer ceramic substrate. Therefore, the structure, shape, and size of any electrode or wiring pattern to be described with respect to a ceramic chip substrate will also be applicable to the structure, shape, and size of any electrode or wiring pattern of a multilayer ceramic substrate.

Before describing specific embodiments of the present disclosure in detail, an example fundamental constitution according to the present disclosure will be described.

### <Fundamental constitution of the mounting substrate>

First, an example fundamental constitution of a mounting substrate according to the present disclosure for mounting a plurality of semiconductor chips thereon will be described. This mounting substrate is one of the plural mounting substrates which have been cut out from a wafer for mounting substrates. When a semiconductor chip(s) is mounted on its top face, each mounting substrate constitutes a chip module. The chip module is to be used by being mounted on a main substrate (mother board). Typically, a semiconductor chip is a semiconductor device having a large-scale integrated circuit formed thereon, but may also be a semiconductor device having a communications circuit or a power circuit formed thereon. The semiconductor to compose a chip is not limited to a single-crystalline silicon, but may also be a wide bandgap semiconductor such as silicon carbide and gallium nitride. On the other hand, the main substrate may typically be a printed-circuit board. The main substrate having the chip module mounted thereon may be used in various apparatuses or appliances, e.g., mobile terminal devices, information appliance devices, home appliance devices, automobile parts, and industrial machines.

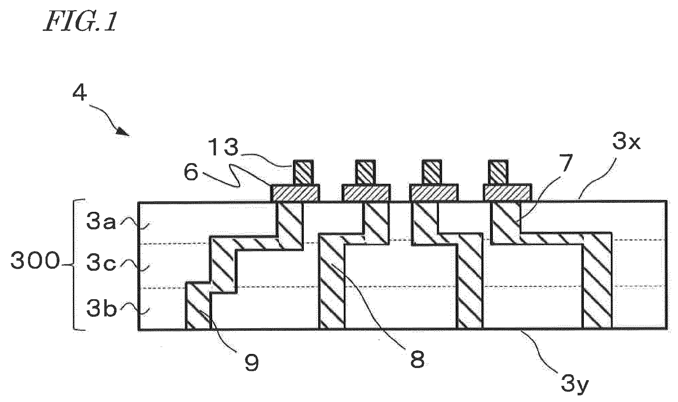

With reference to FIG. **1****,** an example fundamental constitution of the mounting substrate according to the present disclosure will be described.

A mounting substrate **4** is shown to include a ceramic chip substrate (singulated multilayer ceramic substrate) **300** having a top face **3x** and a bottom face **3y**. The ceramic chip substrate **300** includes a top-face ceramic layer **3a** located at the top face **3x,** a bottom-face ceramic layer **3b** located at the bottom face **3y**, and at least one intermediate ceramic layer **3c** interposed between the top-face ceramic layer **3a** and the bottom-face ceramic layer **3b.** In FIG. **1****,** boundaries of the ceramic layer are distinguished by dotted lines, but these are provided for the purpose of explaining the top-face ceramic layer **3a,** the bottom-face ceramic layer **3b,** and the intermediate ceramic layer **3c.** In an actual ceramic chip substrate, the boundaries between the ceramic layers may not be clear, and the boundary portions may appear continuous in an indistinguishable manner; or a boundary may be found within each ceramic layer because of an internal electrode being made, thereby resulting in a plurality of layers.

The multilayer ceramic substrate **3** includes a plurality of top face electrodes **7** in the top-face ceramic layer **3a,** a plurality of bottom face electrodes **9** in the bottom-face ceramic layer **3b,** and a plurality of internal electrodes **8** which provide electrical connection between the plurality of top face electrodes **7** and the plurality of bottom face electrodes **9.** In the example of FIG. **1****,** the intermediate ceramic layer **3c** is a single layer; however, the multilayer ceramic substrate **3** may include a plurality of intermediate ceramic layers **3c.**

Although FIG. **1** illustrates that the ceramic layers **3a**, **3b** and **3c** included in the ceramic chip substrate **300** have an essentially equal thickness, their actual thicknesses are not limited to this example. The sizes of the respective elements in the figures do not necessarily reflect their actual scale and ratio.

The mounting substrate **4** according to the present disclosure includes a wiring pattern **6** formed on the top face **3x** of the ceramic chip substrate **300.** The wiring pattern **6** has a minimum line width which is equal to or less than 2 *µ*m and a minimum line space which is equal to or less than 2 µ m. The wiring pattern **6** may partly have a line width which is greater than 2 *µ* m. Moreover, the line space in the wiring pattern **6** may partially be greater than 2 *µ*m.

Now, the reason why dimensions of the wiring pattern to be formed through photolithography are set as above will be described.

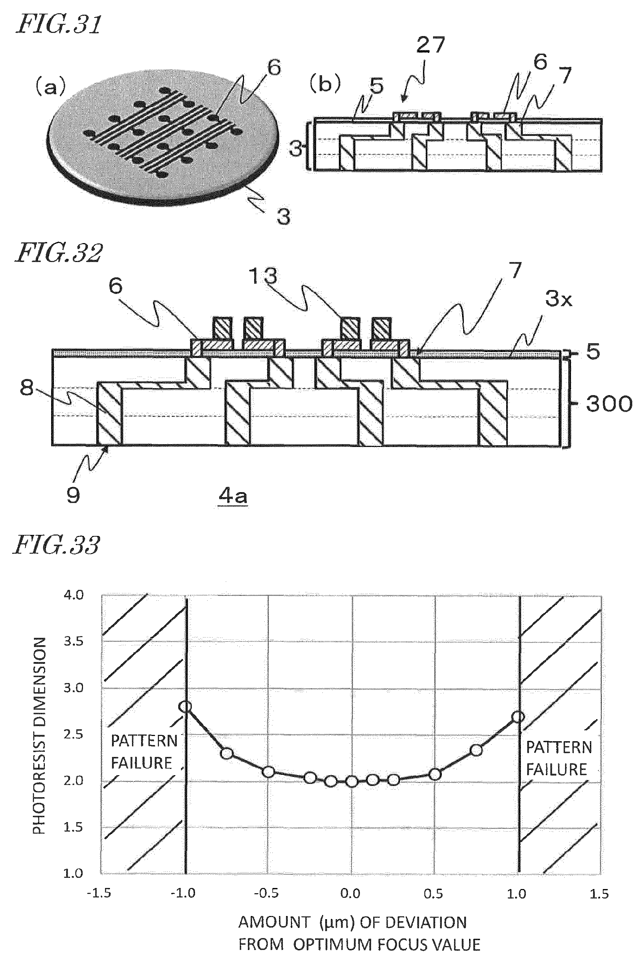

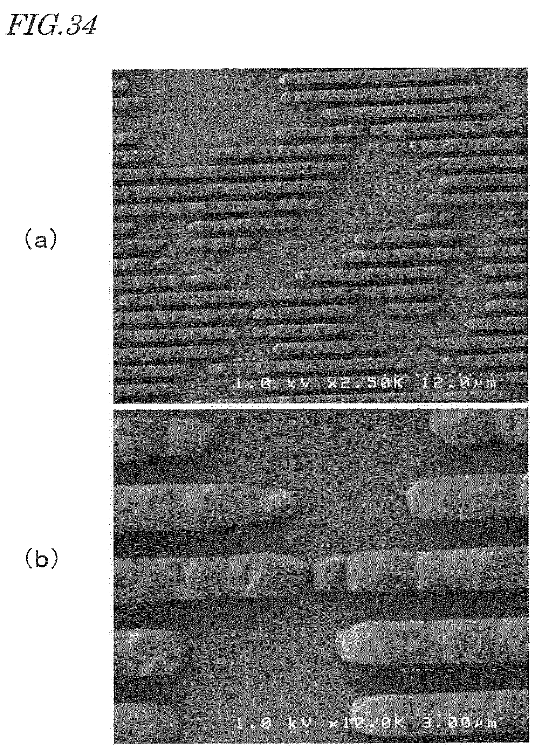

FIG. **33** shows a correlation between amounts of deviation from an optimum focus value and a photoresist dimension. When adjacent portions of a photoresist at an interval of 2 *µ*m, each having a line width of 2 *µ*m, end up being equal to or greater than 3 *µ* m each, then these adjacent portions of photoresist will become bridged. This makes it impossible to form the wiring pattern **6** at the bridged place, whereby a wiring disruption occurs, thus resulting in a pattern failure (see FIG. **34**). On the other hand, if the amount of deviation from optimum focus is within 1 *µ*m, then the photoresist dimension is within 3 *µ* m or less, so that pattern failures do not occur. The optimum focus value is set by measuring the substrate height in a region to be subjected to exposure, in such a manner that least deviation will be incurred. This definition can be regarded as the same as an SFQR-based height range within a region, which will be described later. In other words, it can be said that the aforementioned amount of deviation from the optimum focus value is synonymous to the value defined under SFQR. Therefore, if an SFQR is measured to be equal to or less than 2 *µ*m, then, without allowing a pattern failure to occur, it is possible to form a wiring pattern having a minimum line width which is equal to or less than 2 *µ*m and a minimum line space which is equal to or less than 2 *µ*m.

The region in which SFQR is to be measured is, for example, a 20 mm x 20 mm region. A 20 mm x 20 mm region is a convenient example of what might be any region, and may be set to arbitrary values conforming to the measurement apparatus. For example, it may be 15 mm x 15 mm or 25 mm x 25 mm. An evaluation region of 20 mm x 20 mm or smaller is likely to produce a smaller SFQR, thus naturally satisfying being equal to or less than 2 *µ*m. If it is above 20 mm x 20 mm, a 20 mm x 20 mm evaluation region may be selected from within that region, such that an SFQR thereof is equal to or less than 2 *µ*m. Moreover, since various sizes and shapes may potentially be adopted in the actual product, the evaluation region may be different in size and shape from the actual region to be subjected to exposure, or may be different in size and shape from the chip area that defines a unit into which a wafer for mounting substrates is cut and split.

In the example of FIG. **1****,** a plurality of bump electrodes **13** are provided on the wiring pattern **6.** The bump electrodes **13** may come in electrical contact, and thus achieve connection, with semiconductor chips to be mounted on the mounting substrate **4.**

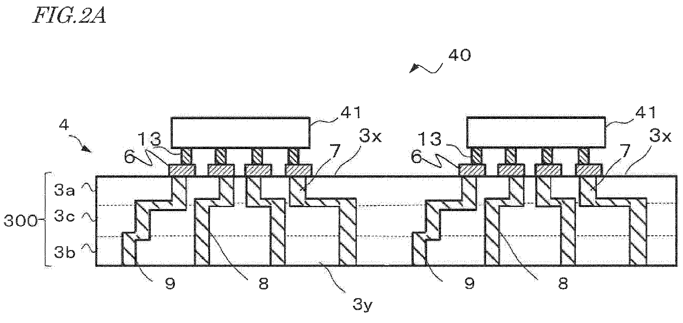

FIG. **2A** shows an example constitution of a chip module **40.** The illustrated chip module **40** includes a mounting substrate **4** with a similar constitution to that shown in FIG. **1****,** and a plurality of semiconductor chips **41** mounted on the mounting substrate **4.** The semiconductor chips **41** in the chip module **40** can be electrically connected with one another by way of a wiring pattern, electrodes, or internal circuitry of the mounting substrate **4.**

Plural semiconductor chips are mounted on the mounting substrate **4,** and electrical connection between the semiconductor chips is mainly achieved by way of a wiring pattern **6** which is formed on the top face **3x** of the ceramic chip substrate **300** of the mounting substrate **4,** thereby allowing signal transmission. For example, a High Bandwidth Memory as specified in JESD235 includes pads with a diameter of 25 *µ*m, to be connected with the wiring pattern **6,** being disposed at a smallest pitch of 55 *µ*m. Moreover, when a wiring pattern **6** (8 to 11 wires) corresponding to a required number of channels is to be disposed in a manner of extending between pads, the minimum line width and minimum line space of the wires need to be equal to or less than 2 *µ*m.

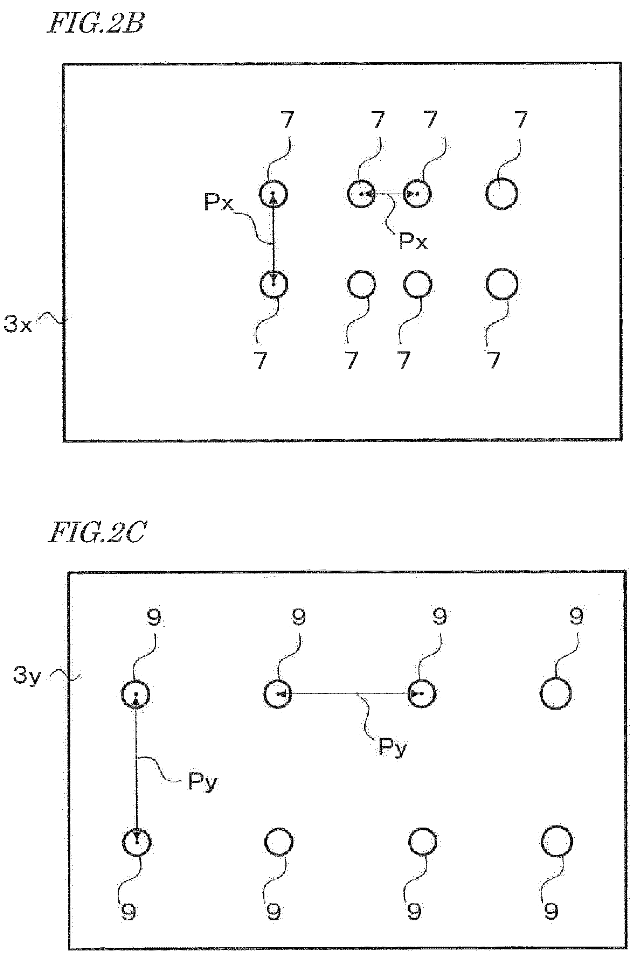

FIG. **2B** and FIG. **2C** are plan views schematically showing a portion of an example arrangement of top face electrodes **7** and a portion of an example arrangement of bottom face electrodes **9,** respectively. In FIG. **2B****,** an inter-electrode-central distance of the top face electrodes **7** is indicated as "Px". Similarly, in FIG. **2C****,** an inter-electrode-central distance of bottom face electrodes **9** is indicated as "Py". The distance **Px** between electrode centers of the top face electrodes **7** may take plural values for the same ceramic chip substrate. Therefore, the smallest value among these plural values is defined as the "inter-electrode-central distance of top face electrodes". Similarly, the distance **Py** between electrode centers of the bottom face electrodes **9** may take a plural values for the same ceramic chip substrate; therefore, the smallest value among these plural values is defined as the "inter-electrode-central distance of the bottom face electrodes".

In the ceramic chip substrate **300** according to the present disclosure, the inter-electrode-central distance of the top face electrodes **7** is smaller than the inter-electrode-central distance of the bottom face electrodes **9.** Since the internal electrodes **8** of the ceramic chip substrate **300** include electrically conductive layers extending along substrate in-plane directions, the top face electrodes **7** can be appropriately connected to their corresponding bottom face electrodes **9,** even if the arrangement of the top face electrodes **7** and the arrangement of the bottom face electrodes **9** are different.

Note that the term "inter-electrode-central distance" means, regarding two adjacent electrodes on the top face or the bottom face of the ceramic chip substrate, the length of a line segment connecting the centers of the respective electrodes. Moreover, the "center of an electrode" is an area centroid of a cross section of the electrode on the top face or the bottom face of the ceramic chip substrate. Although the example electrodes illustrated in FIG. **2B** and FIG. **2C** have circular cross sections, the cross-sectional shape of each electrode is not limited to a circular shape, but may be an elliptical shape or a polygon, e.g., rectangular. Also, the cross-sectional sizes of the electrodes do not need to be equal.

In the ceramic chip substrate 300 included in the mounting substrate **4** according to the present disclosure, the top face **3x** of the ceramic chip substrate **300** is planarized so that an SFQR (Site Front Least Squares Ranges) in a 20 mm x 20 mm region is equal to or less than 2 *µ*m.

The meaning of SFQR will be described later, along with the meanings of other terms that are indicative of planarity, i.e., SBIR (Site Back Surface Referenced Ideal Ranges) and GBIR (Global Back Ideal Ranges). In one aspect, the top face **3x** of the ceramic chip substrate **300** is planarized so that an SBIR in a 20 mm x 20 mm region is equal to or less than 2 *µ*m. In another aspect, the top face **3x** of the multilayer ceramic substrate **3** is planarized so that a GBIR thereof is equal to or less than 2 *µ*m.

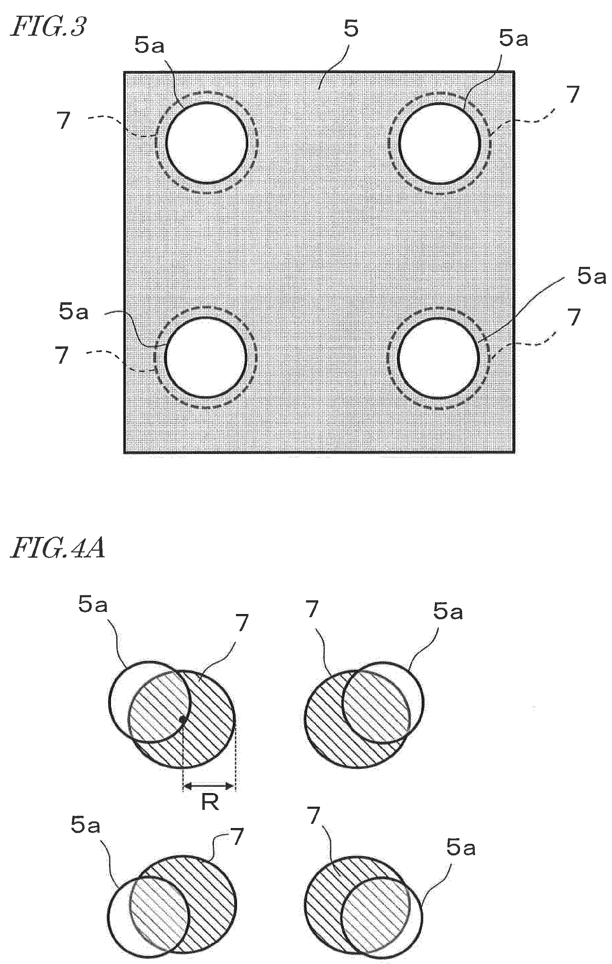

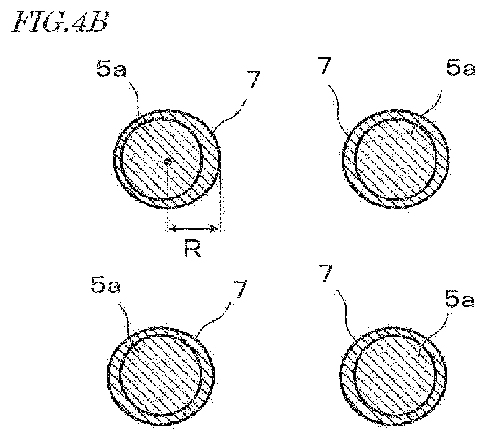

Such planarization and photolithography steps are to be applied to the multilayer ceramic substrate before being split. Therefore, the description with reference to FIG. **3,** FIG. **4A****,** and FIG. **4B** below will concern the "multilayer ceramic substrate" before being split.

In the below-described embodiments, a dielectric layer (not shown in FIG. 1) is provided between the top face **3x** of the ceramic chip substrate or the multilayer ceramic substrate **3** and the wiring pattern **6.** This dielectric layer has a plurality of holes which electrically connect the respective top face electrodes **7** to the wiring pattern **6.** The plurality of top face electrodes **7** are aligned respectively with the plurality of holes.

FIG. **3** is an upper plan view of a portion of a dielectric layer **5** having a plurality of holes **5a.** In the example shown in FIG. **3****,** four holes **5a** are made in the dielectric layer **5,** each hole **5a** being aligned with a top face electrode **7** on the top face **3x** of the multilayer ceramic substrate **3.** For simplicity, the wiring pattern **6** and the bump electrodes **13** are omitted from illustration in FIG. **3****.** In actuality, the top face electrodes **7** are electrically connected with the wiring pattern 6 through the respective holes **5a**. The shapes and positions of the holes **5a** are defined in a photolithography step, as are the shapes and positions of the wiring pattern formed thereon.

Generally, a multilayer ceramic substrate is produced by firing a structure in which green sheets of a ceramic are stacked. Therefore, a multilayer ceramic substrate may deform due to contraction associated with the drying of a solvent in the interior of the green sheets before a firing step, expansion associated with the pressing during stacking, and so on, and further undergo contractions along its substrate in-plane directions and thickness direction before and after the firing step. Since it is difficult to control the degree of such deformation, the top face of the multilayer ceramic substrate loses planarity, thus making it difficult to form minute structures through a photolithography step. Specifically, due to deformation along substrate in-plane directions, the positions of the plurality of top face electrodes **7** along in-plane directions are likely to shift from their target positions (i.e., reference positions by design). Once such deviations in position of the top face electrodes occur, even if minute structures (holes and wiring pattern of the dielectric layer) are formed on the top face of the multilayer ceramic substrate through photolithography, alignment with respect to the underlying structures (which herein are the top face electrodes **7**) cannot be appropriately realized. In other words, electrical connection may not be achieved in some cases.

FIG. **4A** is an upper plan view showing how the center positions of the top face electrodes **7** may be shifted from target positions. In the example of FIG. **4A****,** when the radius of a top face electrode **7** on the upper face is R *µ*m, the distance from the electrode center of the top face electrode **7** to the center of the hole **5a** in the dielectric layer is on the order of R *µ* m. As a result of such deviations in position, the holes **5a** in the dielectric layer **5,** which are formed through photolithography, are not sufficiently aligned with respect to the top face electrodes **7.** As the deviation in position escalates, an increase in contact resistance or a contact failure will occur. For this reason it has been believed impossible, so long as using a conventional multilayer ceramic substrate, to form on the multilayer ceramic substrate a fine line pattern that can only be formed through photolithography, and electrically connect it to the top face electrodes. Such misalignments may exert influence when minute structures are to be formed on the multilayer ceramic substrate through photolithography. The minute structures are not limited to holes in the dielectric layer, and may be created by forming a wiring pattern without even providing a dielectric layer on the top face of the multilayer ceramic substrate, or allowing wiring patterns to intersect with covering of a dielectric layer being provided only in necessary portions, for example. In such cases, deviations in position may occur between the wiring pattern (s) /dielectric layer covering and the top face electrodes **7,** according to conventional techniques.

However, according to an embodiment in the present disclosure, planarity of the multilayer ceramic substrate is enhanced, and formation of microstructures through photolithography is enabled, and an index such as SFQR mentioned above is adjusted to an appropriate range. Moreover, contraction along in-plane directions on the multilayer ceramic substrate is kept to 1% or less, thus bringing the positions of the top face electrodes **7** closer to the target values more easily. Moreover, by enhancing planarity at the top face of the multilayer ceramic substrate, microstructures which are formed through photolithography are allowed to connect to the top face electrodes **7** with a high precision. In the specific embodiments described later, the distance from the center position of each top face electrode **7** to the center position of the corresponding hole **5a** is equal to or less than a radius of the top face electrodes.

FIG. **4B** is an upper plan view showing an example where the top face electrodes **7** are aligned with the holes **5a** in the dielectric layer **5**. In this example, given that the upper face of each top face electrode **7** has a radius of R µ m, the distance from the electrode center of the top face electrode **7** to the center of the hole **5a** in the dielectric layer is shorter than R *µ* m. In the below-described embodiments, the radius of the upper face of each top face electrode **7** is about 40 *µ*m; therefore, in order to align the top face electrodes **7** with the holes **5a** in the dielectric layer **5,** deviations in position of the top face electrodes due to contraction are kept to 35 *µ* m or less, typically 30 *µ* m or less. When the radius of the upper face of each top face electrode **7** is R *µ* m, it is preferable that the distance from the electrode center of the top face electrode **7** to the center of the hole **5a** in the dielectric layer is shorter than R/2 *µ*m.

### <Fundamental constitution of a method of producing a wafer for mounting substrates>

According to the present disclosure, it is necessary to use a multilayer ceramic substrate with controlled contraction, and apply a fine pattern fabrication technique to its surface through photolithography. The target of the photolithography step is a multilayer ceramic substrate. The multilayer ceramic substrate includes a top-face ceramic layer located at the top face, a bottom-face ceramic layer located at the bottom face, a plurality of top face electrodes in the top-face ceramic layer, a plurality of bottom face electrodes in the bottom-face ceramic layer, and a plurality of internal electrodes which provide electrical connection between the plurality of top face electrodes and the plurality of bottom face electrodes. The inter-electrode-central distance of the plurality of top face electrodes is smaller than the inter-electrode-central distance of the plurality of bottom face electrodes.

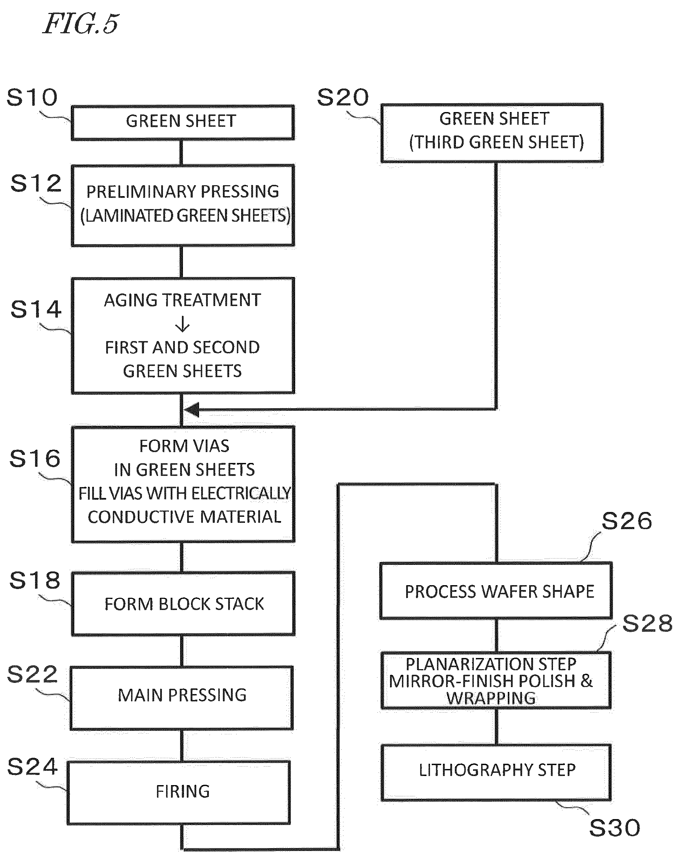

With reference to the flowchart of FIG. **5****,** a fundamental constitution of a method of producing a wafer for mounting substrates will be described.

First, at step **S10**, a plurality of green sheets from which to form a top-face ceramic layer and a bottom-face ceramic layer of a multilayer ceramic substrate are provided. The thickness of each green sheet may be e.g. 100 *µ* m to 200 *µ*m.

At step **S12,** two layers or three or more layers of green sheets are placed on top of one another, and subjected to preliminary lamination, thus producing stacked ceramic green sheets from each of which to form a top-face ceramic layer or a bottom-face ceramic layer, respectively. The preliminary lamination may be performed while pressurizing the stacked ceramic green sheet in the thickness direction. During pressurization, the stacked ceramic green sheet may be heated to e.g. about 60 to about 80°C. The stacked ceramic green sheet in a preliminarily laminated state may have a thickness of e.g. 300 µm to 500 *µ* m. In an embodiment in the present disclosure, by ensuring that the top-face ceramic layer and the bottom-face ceramic layer are each relatively thick, a processing margin is obtained for sufficiently planarizing the top face of the multilayer ceramic substrate after firing, which will otherwise have ruggednesses, thereby being able to perform a high-precision surface machining while preventing disruptions, etc., of the internal electrodes. Thus, the thickness of the stacked ceramic green sheet is to be determined while factoring in the thickness of a surface layer to be removed through a subsequent planarization.

At step **S14,** each stacked ceramic green sheet is subjected to aging. Aging is a treatment which is performed to relax stress that builds within a green sheet. Aging may include various treatments by which stress relaxation can be achieved. As an aging treatment, a treatment of being left at room temperature for a long time (e.g. 24 hours or longer) may be performed, or a heat treatment of elevating the temperature, etc., may be performed. The temperature in the heat treatment may be e.g. about 60 to about 100°C. The time of the heat treatment may be set to e.g. about 30 to about 320 minutes. Thereafter, a treatment at room temperature for e.g. about 24 hours may be performed. The aging treatment is performed to restrain the first and second green sheets from deforming before the firing step. The aging treatment eliminates the aforementioned deviations in position between the top face electrodes **7** and the holes **5a** in the dielectric layer, whereby minute structures based on photolithography are accomplished.

On the other hand, at step **S20,** at least one or more green sheets (third green sheet) is provided in addition to the first and second green sheets. The third green sheet defines at least one or more internal ceramic layers located between the top-face ceramic layer and the bottom-face ceramic layer in the multilayer ceramic substrate.

The first green sheet and second green sheet as produced at step **S14** involve a step of providing a plurality of green sheets each having a thickness which is substantially equal to the thickness of the third green sheet, and a step of stacking plural green sheets to produce each of the first green sheet and second green sheet. Doing so basically makes it possible to obtain the first and second green sheets and the third green sheet by using green sheets of the same thickness which are produced by the same method. For example, when just three layers of green sheets respectively having a thickness of 150 *µ*m are placed on top of one another to produce each of the first and second green sheets, the first and second green sheets will each have a thickness of e.g. about 450 *µ*m, although subject to some variation due to pressure or the like. On the other hand, when a third green sheet composed of one layer or a plurality of stacked layers is produced by using a green sheet(s) having a thickness of 150 *µ*m, each third green sheet will have a thickness of 150 *µ*m. As will be appreciated, the first and second green sheets may be produced by using green sheets which are thicker than the third green sheet in the first place.

Next, at step **S16,** a plurality of holes (vias or throughholes) are formed in the first, second, and third green sheets. These holes define the shapes and positions of the top face electrodes, the bottom face electrodes, and the internal electrodes. The holes may be formed through laser irradiation of each of the first, second, and third green sheets. The holes may have a diameter of e.g. 30 to 150 *µ*m. For example, by irradiating the same position on a green sheet with 10 instances of pulse laser with a power of 2 millijoules (mJ), a throughhole with a diameter of about 80 µm can be formed at a desired position of the green sheet.

Next, the plurality of holes of the first, second, and third green sheets are filled with an electrically conductive material. Filling with the electrically conductive material can be achieved by a printing technique. Throughholes with a diameter of about 80 *µ*m can be densely filled with the electrically conductive material, even to a depth of about 450 *µ*m. After firing, the electrically conductive material functions as electrodes.

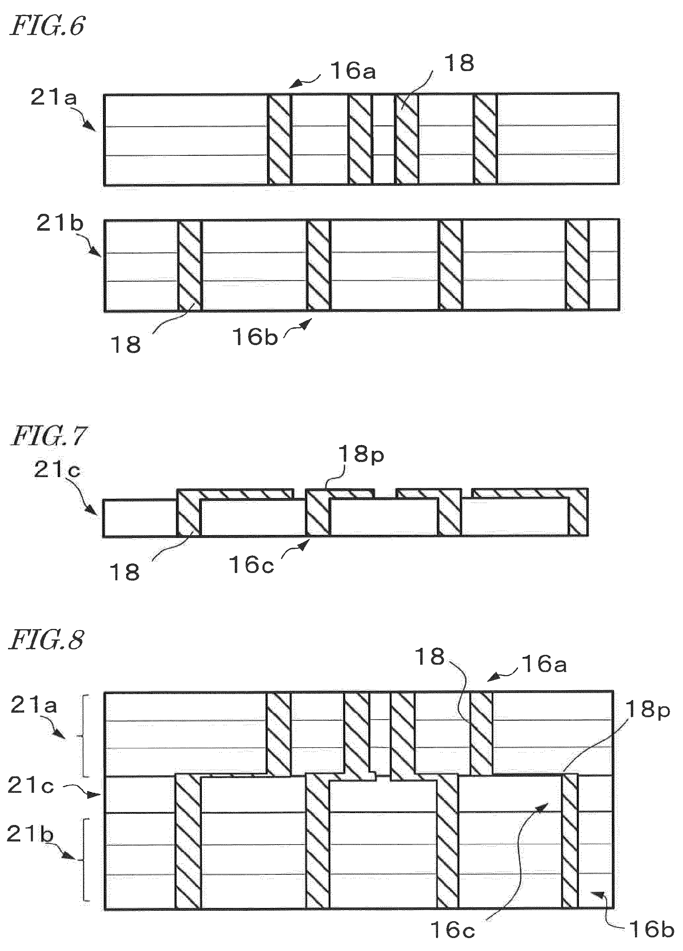

Moreover, by providing an electrically conductive material on the principal face of a green sheet, a conductive pattern can be formed on the green sheet. A printing technique can be used for the formation of the conductive pattern, for example. Herein, at the same time as filling the holes made in the third green sheet with the electrically conductive material, a conductive pattern is formed on one of the principal faces of the third green sheet (see FIG. **7** to be described later). Formation of the conductive pattern may be performed before or after filling the holes with the electrically conductive material. Electrodes to electrically connect the top face electrodes with the bottom face electrodes, e.g., a conductive pattern, an electrically conductive material, and the like, are regarded as internal electrodes. As used herein, an "internal electrode" may encompass any and all conductors that electrically connect the top face electrodes with the bottom face electrodes. In the case where the internal electrodes are made from the same material as the top face electrodes and bottom face electrodes, these will be integrally coupled, such that the internal electrodes do not need to be distinguished from the top face electrodes and bottom face electrodes. In the present specification, when used in its broadest sense, the term "internal electrode" may have the same meaning as electrically conductive material being located in the interior of the multilayer ceramic substrate.

FIG. **6** shows an exemplary cross section of the first and second green sheets after being filled with the electrically conductive material. In the constitution illustrated in FIG. **6****,** the first green sheet **21a** and the second green sheet **21b** are each formed by stacking three layers of green sheets. Holes **16a** made in the first green sheet **21a** and holes **16b** made in the second green sheet **21b** are filled with an electrically conductive electrode material **18.** As shown in in the figure, typically, the inter-central distance of the holes **16a** in the first green sheet **21a** is smaller than the inter-central distance of the holes **16b** in the second green sheet **21b.**

FIG. **7** shows an exemplary cross section of the third green sheet after being filled with the electrically conductive material. In the constitution illustrated in FIG. **7****,** the third green sheet **21c** does not have a multilayer structure. The third green sheet **21c** shown in FIG. **7** has a conductive pattern **18p** on its upper face. As shown in the figure, holes **16c** made in the third green sheet **21c** are filled with the electrode material **18.** Herein, the holes **16c** have the same arrangement as that of the holes **16b** in the second green sheet **21b.** As shown in the figure, the conductive pattern **18p** has portions overlapping the holes **16c.** The conductive pattern **18p** may be provided on the upper face of the second green sheet **21b.**

At step **S18,** the first to third green sheets are stacked so that the third green sheet is sandwiched between the first green sheet and the second green sheet, thus forming a laminated ceramic green sheet. At this time, for constraining purposes, it is preferable to keep the upper face and the lower face of the laminated ceramic green sheet in contact with constraining layers of another base material etc., which is not sintered at the same temperature as the green sheets, for example.

FIG. 8 shows a cross section in which the first green sheet **21a** and the second green sheet **21b** shown in FIG. **6** and the third green sheet **21c** shown in FIG. **7** are stacked. In the constitution illustrated in FIG. **8****,** the third green sheet **21c** is interposed between the first green sheet **21a** and the second green sheet **21b,** so that its principal face having the conductive pattern **18p** formed thereon opposes the first green sheet **21a.** As a result, the electrode material **18** in the holes **16a** in the first green sheet **21a** comes in contact with the conductive pattern **18p** on the third green sheet **21c.** Moreover, in the example illustrated herein, the holes **16c** in the third green sheet **21c** and the holes **16b** in the second green sheet **21b** have the same arrangement. Therefore, as the third green sheet **21c** and the second green sheet **21b** become stacked, the electrode material **18** in the holes **16c** of the third green sheet **21c** comes in contact with the electrode material **18** in the holes **16b** of the second green sheet **21b.**

At step **S22** (FIG. **5**), the laminated ceramic green sheet in a constrained state by the base material is mounted into a frame, and a main lamination is performed for the laminated ceramic green sheet. The main lamination may be performed, for example, through heating to 60 to 90°C and application of a pressure of 200 to 500 kg/cm² (=19.6 to 49 MPa). Thereafter, the laminated ceramic green sheet is taken out of the frame, and the base material for constraining purposes is removed.

At step **S24,** the laminated ceramic green sheet is fired. The firing may be conducted at a temperature of 900°C for 2 hours, for example. At the firing, it is preferable to press the upper face and the lower face of the laminated ceramic green sheet with a plate-like setter.

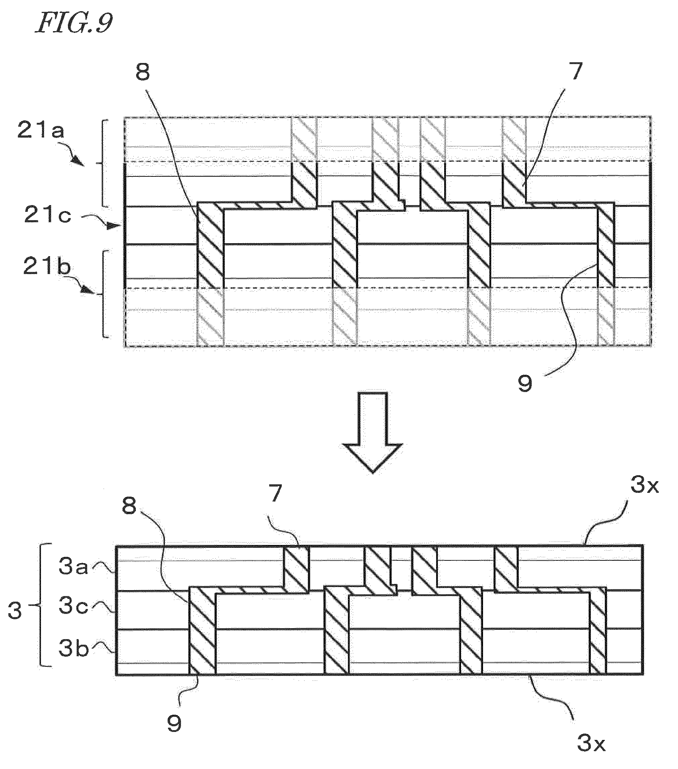

The upper portion of FIG. **9** shows a cross section of the sintered ceramic body, whereas the lower portion is a cross-sectional view schematically showing the multilayer ceramic substrate after polishing. Through the firing step, a sintered body having a structure in which the top-face ceramic layer **3a,** the intermediate ceramic layer **3c,** and the bottom-face ceramic layer **3b** are stacked is obtained. At this firing step, the electrically conductive material that is contained in the electrode material **18** and the conductive pattern **18p** also becomes dense in texture. The firing forms the plurality of top face electrodes 7 in the top-face ceramic layer **3a,** the plurality of bottom face electrodes **9** in the bottom-face ceramic layer **3b,** and the plurality of internal electrodes **8.** For example, by providing a conductor pattern **18p** (see FIG. **8**) on a principal face of the third green sheet **21c** in advance, internal electrodes **8** having an electrically conductive layer extending along in-plane directions of the intermediate ceramic layer **3c** can be formed. As shown in the figure, the internal electrodes **8** have portions where they are connected with the top face electrodes **7** and the bottom face electrodes **9.** As a result, by way of the internal electrodes **8,** the top face electrodes **7** are electrically connected with the corresponding bottom face electrodes **9.**

As both faces of the sintered ceramic body are polished, portions marked by broken lines in the upper portion of FIG. **9** are removed, and as shown in the lower portion of FIG. **9****,** a multilayer ceramic substrate **3** whose top face and bottom face are planarized is obtained. Since the sintered ceramic body includes the internal electrodes **8** in its interior, even if the arrangement of the top face electrodes **7** and the arrangement of the bottom face electrodes **9** of the multilayer ceramic substrate **3** are different, the top face electrodes **7** and the corresponding bottom face electrodes **9** are allowed to be connected to each other.

At step **S26,** the sintered ceramic body is processed into a disk shape with a laser, for example (shaping step). As a result, a disk-shaped multilayer ceramic substrate is obtained. According to an embodiment in the present disclosure, it is ensured that, before and after the step of firing the laminated ceramic green sheet, the multilayer ceramic substrate contracts by a distance of only 1% or less in any in-plane direction. Therefore, deviations of the top face electrodes **7** from the target values of their in-plane positions can be reduced.

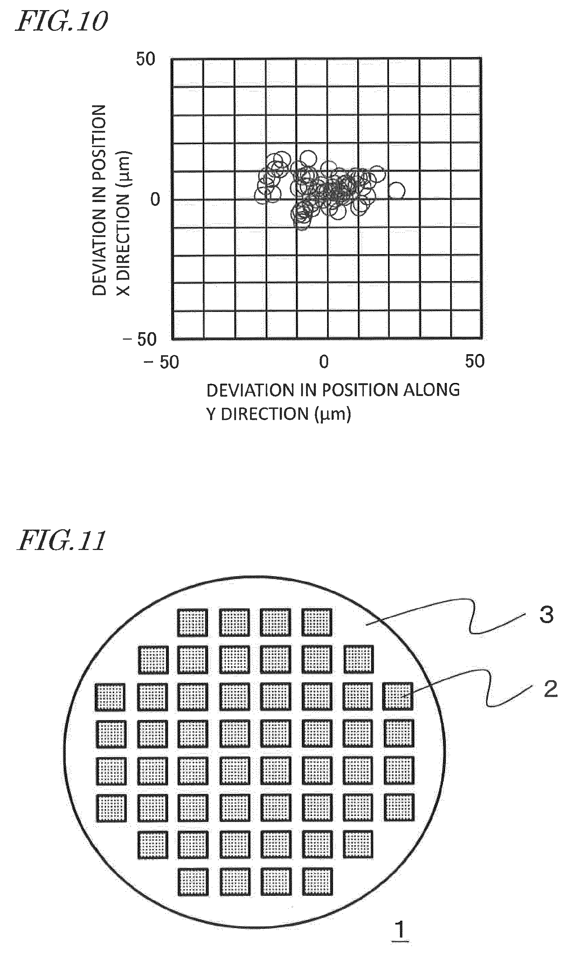

FIG. **10** is a graph in which deviations of top face electrodes from the target positions are plotted. FIG. **10** shows measurement results of amounts of shift of the top face electrodes from the target values, on a disk-shaped multilayer ceramic substrate (diameter: 150 mm). In this multilayer ceramic substrate, 20 × 20 top face electrodes (diameter: 80 µm) are formed in square regions with each side measuring 3 mm, which are disposed at a predetermined pitch. The results shown herein indicate measurements for 16 top face electrodes as extracted symmetrically with respect to an origin, which is the center of the multilayer ceramic substrate. The points of measurement correspond to the positions of the four vertices of a square. In the example shown in FIG. **10**, deviations in position of the top face electrodes due to contraction are in the range of 30 µm or less. In the example shown in FIG. **10****,** 3 σ along the X direction is 29 µm, and 3σ along the Y direction is 15 µ m.

At step **S28** (FIG. **5**), a planarization step for the multilayer ceramic substrate is performed. The planarization process for the multilayer ceramic substrate is typically performed by grinding, lapping, CMP (chemical mechanical polishing), or the like. By forming thickened ceramic layers on both faces of the multilayer ceramic substrate, and respectively processing both faces, it becomes possible to eliminate warpage and undulation and achieve a sufficiently planarized state. Therefore, it is ensured at least in the top face that an SFQR (Site Front Least Squares Ranges) or an SBIR (Site Back Surface Referenced Ideal Ranges) in a 20 mm x 20 mm region is equal to or less than 2 µm. Note that, in the multilayer ceramic substrate both faces of which have been processed, it is not necessary for any and every portion of the top face (or the bottom face) of the multilayer ceramic substrate to satisfy the condition that an SFQR or SBIR in a 20 mm x 20 mm region be equal to or less than 2 µ m. When the multilayer ceramic substrate is split into a plurality of regions by the units of 20 mm x 20 mm, it suffices if the condition that an SFQR in a 20 mm x 20 mn region be equal to or less than 2 µm is satisfied in at least 50% or more of the plurality of regions; or, the condition that an SBIR in a 20 mm x 20 mm region be equal to or less than 2 µm may be satisfied.

Note that, by processing both faces of the multilayer ceramic substrate, the thicknesses of the top-face ceramic layer and the bottom-face ceramic layer may decrease to about a half of their initial values, for example. However, since the thicknesses of the first and second green sheets are set sufficiently large so as to account for the thicknesses of the portions to be removed through polishing, the top-face ceramic layer and the bottom-face ceramic layer will never disappear. (FIG. **9**)

At step **S30,** on the planarized top face of the multilayer ceramic substrate, microstructures such as a wiring pattern are formed through lithography (lithography step). Specifically, by photolithography, a wiring pattern having a minimum line width which is equal to or less than 2 µm and a minimum line space which is equal to or less than 2 µm is formed on the top face of the multilayer ceramic substrate. Thus, a wafer for mounting substrates according to an embodiment in the present disclosure is produced. Bump electrodes may be provided on the wiring pattern by using a known method.

Note that multilayer ceramic substrate produced at step **S28** may be marketed, before a wiring pattern is formed thereon. Since the multilayer ceramic substrate according to the present disclosure has a smooth top face, it will be easy to form a wiring pattern through photolithography.

Hereinafter, with reference to the drawings, embodiments according to the present disclosure will be described in detail. The present disclosure is not limited thereto. The description of each embodiment will apply also to other embodiments, unless specified otherwise. Dimensions in the figures are mere exemplifications for the sake of explanation, and may be inconsistent with the actual ratio.

### [first embodiment]

FIG. **11** is an upper plan view of a wafer for mounting substrates according to the present disclosure. The wafer for mounting substrates **1** shown in FIG. **11** includes a multilayer ceramic substrate **3.** A plurality of chip areas **2** are concentrated on a top face of the multilayer ceramic substrate **3.** By splitting the wafer for mounting substrates **1** in a manner of cutting the wafer for mounting substrates **1** so as to include chip areas, a plurality of mounting substrates are obtained. The shape of the wafer for mounting substrates **1** may be e.g. a disk shape with a diameter of 150 mm or more, so that the machining process for conventional Si wafers is available. The shape of the wafer for mounting substrates **1** may be any shape other than a disk shape, too. It will be advantageous to dispose the chip areas **2** so that a large number of mounting substrates will be obtained from a single wafer for mounting substrates **1,** and the shape of the wafer for mounting substrates **1** may be arbitrarily designed in accordance with the size of the chip areas **2.** However, at handling, foreign matter is likely to adhere to an area spanning 1 mm from the outer periphery of the multilayer ceramic substrate **3.** Therefore, it will be advantageous not to dispose any chip areas **2** in this range.

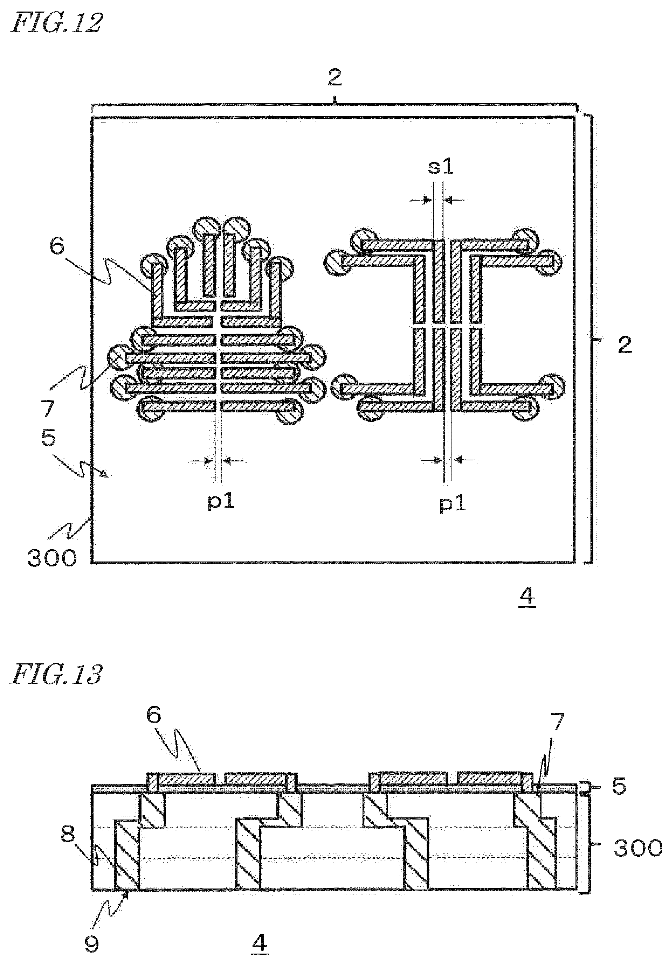

FIG. **12** and FIG. **13** show examples of a mounting substrate **4** which has been individually cut out from the wafer for mounting substrates **1.** The mounting substrate **4** including a chip area **2** has a dielectric layer **5** on the top face of the multilayer ceramic substrate **3,** with a wiring pattern **6** being formed on its upper face. The wiring pattern **6** is connected at one end to each top face electrode **7** of the multilayer ceramic substrate **3,** such that the top face electrodes **7** are electrically connected to bottom face electrodes **9** through internal electrodes **8** of the multilayer ceramic substrate **3.** The multilayer ceramic substrate **3** includes a dielectric whose main components are Al₂O₃ and SiO₂, as well as the internal electrodes **8,** the top face electrodes **7,** and the bottom face electrodes **9.** The internal electrodes **8,** the top face electrodes **7,** and the bottom face electrodes **9** are made of Ag, for example. The multilayer ceramic substrate **3** may include the dielectric layer **5,** the wiring pattern **6,** and the like in the chip area **2** on its top face. The wiring pattern **6** electrically interconnects semiconductor chips. The wiring pattern **6** can be arbitrarily designed in accordance with the specifications of semiconductor chips to be mounted on the mounting substrate **4.** Elements such as varistors for preventing overcurrents may be formed midway in the pattern.

In the present specification, when the wiring pattern **6** is viewed from a direction perpendicular to the top face of the multilayer ceramic substrate **3** or the ceramic chip substrate, the width of a portion which is narrowest in the wiring pattern **6** is referred to as a minimum line width (i.e., the width indicated by arrow **s1** in FIG. **12**), and the interval of a portion at which the pattern is parted by the narrowest spacing is referred to as the minimum line space (i.e., the interval indicated by arrow **p1** in FIG. **12**). In an embodiment in the present disclosure, the minimum line width **s1** in the wiring pattern **6** is equal to or less than 2 µm, and the minimum line space **p1** is greater than 0 µm and equal to or less than 2 µm. The thickness of the wiring pattern **6** can be arbitrarily designed in accordance with the specifications as to electrical resistance, etc. However, from the standpoint of suppressing disruptions and the like, it will be advantageous if the thickness of the wiring pattern **6** is also equal to or less than 2 µm, as is the case with the minimum line width.

According to a study by the inventors, if an SFQR in a 20 mm x 20 mm evaluation region is equal to or less than 2 µm at the top face of the multilayer ceramic substrate **3,** then a mounting substrate having a fine line pattern **6** with a minimum line width **s1** which is equal to or less than 2 µm and a minimum line space **p1** which is equal to or less than 2 µm can be produced. More preferably, the SFQR is 1 µm or less. Similarly to the top face of the multilayer ceramic substrate **3,** an SFQR of the bottom face of the multilayer ceramic substrate **3** may also be equal to or less than 2 µm.

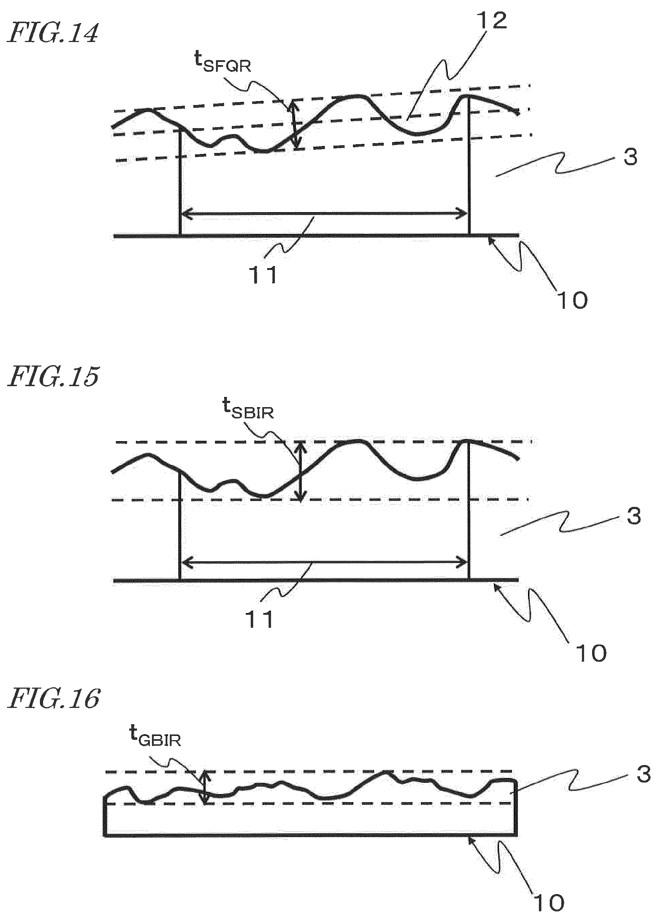

SFQR is an abbreviation of Site Front Least Squares Ranges, which is used as an index of local planarity. FIG. **14** is referred to. In SFQR measurement, as shown in FIG. **14****,** the opposite face **10** from where measurements are to be taken of the multilayer ceramic substrate **3** is allowed to be sucked and fixed onto a flat surface. With the opposite face **10** being flattened, the least-squares method is used to calculate a reference plane **12** based on the surface shape of an evaluation region spanning a certain range (e.g., a 20 mm x 20 mm range (a square with each side being 20 mm long)). In FIG. **14****,** arrow **11** schematically represents the length of one side of the square evaluation region. SFQR is a total of a distance to the highest point of the site surface and a distance to the lowest point on the site surface, as measured from the reference plane **12** (i.e., the distance indicated by arrow **t_{SFQR}** in FIG. **14**). As SFQR decreases, the focusing precision when performing exposure with a stepper (reduction projector) can be improved. In the case of a generic silicon substrate, SFQR is equal to or less than 2 µm, so that a photolithography-based fine pattern fabrication using a stepper is available. On the other hand, generally speaking, an SFQR of a conventional multilayer ceramic substrate does not satisfy the condition that SFQR be equal to or less than 2 µm. Therefore, it is not easy to straightforwardly apply this photolithography process to a multilayer ceramic substrate, and it has at least been necessary to enhance the focusing precision of the stepper. According to an embodiment in the present disclosure, when the multilayer ceramic substrate **3** is zoned into a plurality of evaluation regions by the units of 20 mm x 20 mm, the condition that SFQR be equal to or less than 2 µm can be satisfied in at least 50% of the regions, thus making a photolithography process easily applicable. It is further more preferable if the condition that SFQR be 1 µm or less is satisfied in at least 80% of the evaluation regions. As a result, it is possible to apply a photolithography process in order to realize a fine line pattern.

Some steppers with which to perform exposure have a function of correcting the inclination of a multilayer ceramic substrate with respect to each pattern (also called a shot) for exposure. When any such stepper is used, if SFQR is equal to or less than 2 µm, a precision based on a minimum line width being equal to or less than 2 µm and a minimum line space being greater than 0 µm and equal to or less than 2 µm can be achieved in the wiring pattern. On the other hand, when using a stepper without a function of correcting the inclination of a wafer, SBIR may be used as an index of local planarity. SBIR is an abbreviation of Site Back Surface Referenced Ideal Ranges. In SBIR measurement, as shown in FIG. **15****,** the opposite face **10** from where measurements are to be taken of the multilayer ceramic substrate **3** is allowed to be sucked and fixed onto a flat surface, thereby flatting the opposite face **10.** SBIR is a difference in height between the highest point on the site surface and the lowest point relative to the opposite face **10** (i.e., a height difference indicated by arrow **t_{SBIR}** in FIG. **15**) in an evaluation region spanning a certain range (e.g., a 20 mm x 20 mm range (a square with each side being 20 mm long)). When SBIR is equal to or less than 2 µm, the focusing precision becomes more improved as its value decreases. SBIR is more preferably 1 µm or less. According to an embodiment in the present disclosure, when the multilayer ceramic substrate **3** is zoned into a plurality of evaluation regions by the units of 20 mm x 20 mm, the condition that SBIR be equal to or less than 2 µm can be satisfied in at least 50% of the regions, thus making a photolithography process easily applicable. It is further more preferable if the condition that SBIR be 1 µm or less is satisfied in at least 80% of the evaluation regions. As a result, it is possible to apply a photolithography process in order to realize a fine line pattern.

GBIR may also be used as an index of planarity. GBIR is an abbreviation of Global Back Ideal Ranges, and indicates planarity of the entire wafer surface. In GBIR measurement, as shown in FIG. **16****,** the opposite face **10** from where measurements are to be taken of the multilayer ceramic substrate **3** is allowed to be sucked and fixed onto a flat surface, thereby flattening the opposite face **10.** GBIR is a difference in height between the highest point on the wafer surface and the lowest point relative to the opposite face **10** (i.e., a height difference indicated by arrow **t_{GBIR}** in FIG. **16**), across the entire wafer surface. When GBIR is equal to or less than 2 µm, the focusing precision becomes more improved as its value decreases. GBIR is more preferably 1 µm or less.

Thus, by at least satisfying that SFQR be equal to or less than 2 µm, that SBIR be equal to or less than 2 µm, or that GBIR be equal to or less than 2 µm, it is possible to realize a fine line pattern with a minimum line width being equal to or less than 2 µm and a minimum line space being greater than 0 µm and equal to or less than 2 µm. Once such a wiring pattern has been formed, bump electrodes can be disposed on the wiring pattern so as to correspond to the minute electrode pitch of semiconductor chips. This eliminates the need for an interposer with a silicon substrate, which has conventionally been necessary. The choice as to which of the SFQR, SBIR, and GBIR indices is to be used may be made as appropriate, based on the function of the exposure apparatus. The SFQR index is effective when exposure is performed with a stepper which has a function to correct inclination of a substrate surface, whereas the SBIR index is effective when exposure is to be performed with a stepper not having a function to correct inclination of a substrate surface. The GBIR index is effective when using an aligner which performs universal exposure for the entire substrate surface. It is not necessary for the aforementioned condition to be satisfied with respect to all of the SFQR, SBIR, and GBIR indices; one of them may be selected in accordance with the exposure apparatus to be used. However, it can usually be said that SFQR will be satisfied when the SBIR index is to be used, and further that both SBIR and SFQR will be satisfied when the GBIR index is to be used.

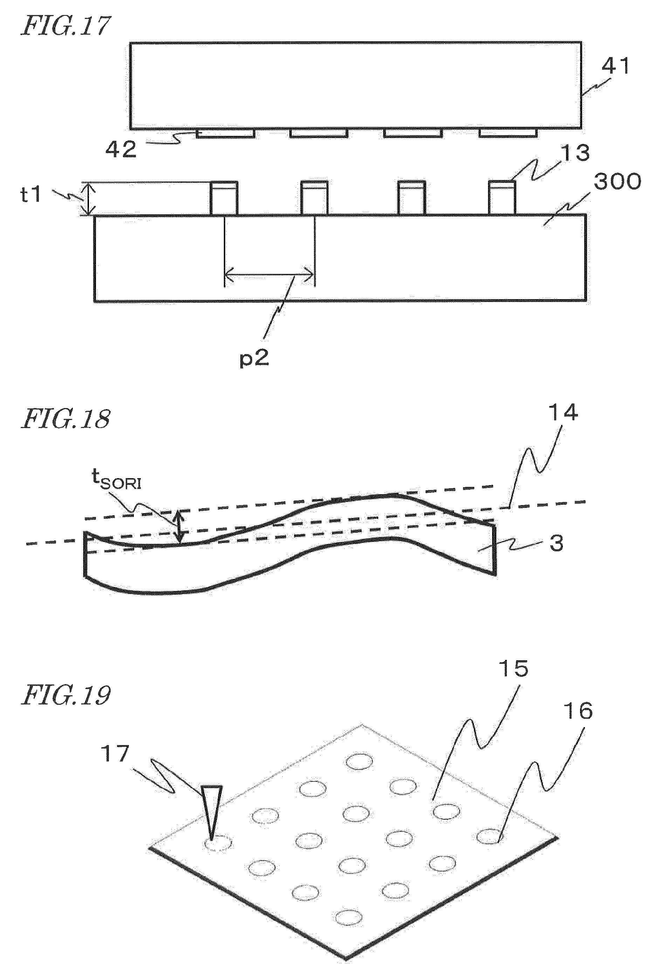

The mounting substrate **4** may include bump electrodes **13** (see FIG. 1). The bump electrodes **13** may be formed all in once on the wafer for mounting substrates **1** in advance, or formed after splitting the wafer for mounting substrates **1.** Examples of the material of the bump electrodes **13** include Cu, Au, Sn, and so on. The bump electrodes **13** may include a two-layer structure or three-layer structure such as Cu/Sn or Cu/Ni/Au. Depending on the design of the electrode pitch for mounting the semiconductor chips **41** on the mounting substrate **4,** 50 µm or less is required as a pitch of the bump electrodes **13.** The pitch **p2** of the bump electrodes **13** and the height **t1** of the bump electrodes **13** are shown in FIG. **17****.** During the bonding of the bump electrodes **13** to electrodes **42** of the semiconductor chip **41,** as one end of each bump electrode **13** (e.g., Sn in Cu/Sn) on the top face whose warpage has been rectified and which has been planarized becomes melted, the discrepancy in height between the electrodes **42** of the semiconductor chip **41** and the opposing bump electrodes **13** can be absorbed.

Note that SORI is, in the multilayer ceramic substrate **3** when not sucked to a flat surface, a sum of a distance to the highest point on the top face of the multilayer ceramic substrate **3** and a distance to the lowest point on the top face of the multilayer ceramic substrate **3,** as measured from a global best-fit reference plane **14** in a non-sucked state (i.e., the distance indicated by arrow **t_{SORI}** in FIG. **18**). The global best-fit reference plane **14** is a reference plane which is calculated by the least-squares method based on the shape of the top face of the entire wafer surface in a state where its opposite face from where measurements are to be taken is not sucked to a flat surface.

The face of the multilayer ceramic substrate **3** that is opposite from its face on which semiconductor chips are to be mounted is, as described earlier, coupled to a main substrate such as a printed circuit board. Therefore, the electrode pitch of the bottom face electrodes **9** (see FIG. **1**) may be about 500 µm to about 1 mm. Bumps may be formed by forming a metal film called UBM (Under Bump Metal) on the bottom face electrodes **9,** and placing solder balls thereon. The UBM may have a multilayer structure such as Ni/Au or Ni/Pd/Au. The material of the solder balls is a lead-free solder, e.g., Sn-Ag-Cu, for example.

Hereinafter, with reference to the drawings, an exemplary method of producing a wafer for mounting substrates according to the present disclosure will be described.

First, green sheets are provided which are obtained by compacting ceramic powder into sheets. As the material of the ceramic powder, it is possible to use a low-temperature co-fired ceramic material, i.e., a so-called LTCC (Low Temperature Co-Fired Ceramics) ceramic, which can be simultaneously fired with an electrically conductive paste such as Ag, Cu, or Au. More preferably, a mixture is used which contains main components Al, Si, Sr, and Ti, as respectively translated into Al₂O₃, SiO₂, SrO, and TiO₂ forms, at 10 to 60 mass% in Al₂O₃ form, 25 to 60 mass% in SiO₂ form, 7.5 to 50 mass% in SrO form, and 20 mass% or less (including 0) in TiO₂ form. As sub-components this mixture may contain, relative to 100 mass% of its main components, at least one selected from the group consisting of Bi, Na, K, and Co, at 0.1 to 10 mass% in Bi₂O₃ form, 0.1 to 5 mass% in Na₂O form, 0.1 to 5 mass% in K₂O form, or 0.1 to 5 mass% in CoO form. Furthermore, this mixture may contain at least one selected from the group consisting of Cu, Mn, and Ag. The mixing ratios for Cu and Mn in this case may be, respectively, 0.01 to 5 mass% in CuO form and 0.01 to 5 mass% in MnO₂ form. The mixing ratio for Ag may be 0.01 to 5 mass%. The low-temperature co-fired ceramic material may contain other inevitable impurities. The above mixture is calcined at 700°C to 850°C, and pulverized to obtain a dielectric ceramic composition of fine-pulverized particles with an average particle size of 0.6 to 2 µm. This dielectric ceramic composition is mixed with an organic binder and a plasticizer, thus obtaining a ceramic slurry. By a doctor blade technique or the like, the ceramic slurry is applied onto a carrier film such as a polyethylene terephthalate film to a uniform thickness, and thereafter the ceramic slurry is dried, thereby obtaining a green sheet with a thickness of several dozen µm to several hundred µm.

Herein, after a plurality of green sheets are produced, two stacks (first and second green sheets) including three layers of green sheets placed on top of one another are prepared in advance. Moreover, one or more layers of green sheet (third green sheet) to be interposed between the first green sheet and second green sheet is provided. In order to suppress deformation before firing, the first and second green sheets are subjected to an aging treatment under the aforementioned condition. The third green sheet may also be subjected to an aging treatment for an improved positional precision.

Next, as shown in FIG. **19****,** a plurality of electrode vias **16** are formed in the green sheet **15.** The green sheet **15** shown in the figure corresponds to any one of the aforementioned first, second, and third green sheets. Since the green sheet **15** profusely contains an organic binder, the electrode vias **16** can be easily formed. From the standpoints of positional precision, processing precision, and processing speed, it is advantageous to form the electrode vias **16** with a laser. For example, by using a carbon dioxide laser **17,** electrode vias **16** having a diameter of 60 µm to 80 µm and extending through the green sheet **15** are formed. The arrangement of the electrode vias **16** to be formed in at least one of the first, second, and third green sheets differs from the arrangement of the electrode vias **16** formed in the other green sheet(s). The electrode vias **16** formed in the first and second green sheets define the top face electrodes and the bottom face electrodes, whereas the electrode vias **16** formed in the third green sheet define the internal electrodes. Herein, a common arrangement of electrode vias **16** is adopted for the second and third green sheets. Moreover, the interval between center positions of the electrode vias **16** in the first green sheet is made smaller than the interval between center positions of the electrode vias **16** in the second and third green sheets.

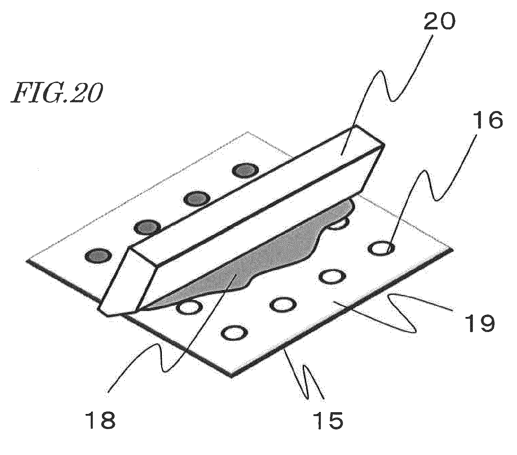

Next, as shown in FIG. **20****,** the electrode vias **16** are filled with an electrode material **18** in paste form by a screen printing technique using a mask **19** and a squeegee **20.** As the electrode material **18,** for example, an electrically conductive paste containing an electrically conductive material such as Ag, Cu, or Au as its main component can be used. In order to accurately embed the electrode material **18** at the positions of the electrode vias **16,** alignment marks may be formed in at least two places of the green sheet **15.** In this case, the mask **19** may also have alignment marks formed at the positions corresponding to the marks on the green sheet **15,** so that alignment is performed by utilizing an image recognition function when they are placed on top of each other. By ensuring that the at least two alignment marks in the green sheet **15** and in the mask **19** are formed as far apart as possible, the alignment precision between the two can be further improved.

Next, with an electrically conductive paste, a circuit pattern for internal wiring is formed on the top face of the green sheet **15** by a screen printing technique. Herein, a circuit pattern for internal wiring is formed on one of the principal faces of the third green sheet. After firing of the green sheet, this circuit pattern at least functions as internal electrodes to electrically connect the top face electrodes with the bottom face electrodes.

This step may be performed after or before the step of filling the electrode vias **16** with the electrode material **18.** Alternatively, by using the mask **19** and squeegee **20,** it may be performed at the same time as filling the electrode vias **16** with the electrode material **18.** The electrode material **18** to fill the electrode vias **16** and the electrode material from which to form a circuit pattern on the top face of the green sheet **15** may be the same material, or electrode materials that are suitable for the respective steps may be selected.

The third green sheet can be constructed by placing a plurality of green sheets **15** on top of one another. The shape and arrangement of the electrode vias **16** and the circuit pattern for internal wiring on the green sheets may vary from sheet to sheet. Moreover, the material composition of the ceramic powder composing the green sheets **15** may vary from sheet to sheet. By combining a plurality of green sheets with different material compositions and/or circuit patterns, it becomes possible to produce complicated three-dimensional circuitry by utilizing not only in-plane directions but also the thickness direction of the green sheets. For example, it may be possible to create a capacitor by forming electrode patterns so as to sandwich a green sheet containing a material having a high dielectric constant, or create an inductor by forming a spiral-shaped electrode pattern. Moreover, by punching out a portion of the green sheet (s) with a die or the like, it would be possible to provide a cavity structure on the multilayer ceramic substrate. In an embodiment in the present disclosure, a multilayer ceramic substrate is formed by stacking green sheets. Therefore, for each green sheet, the shape and/or circuit pattern thereof can be altered, whereby a three-dimensional structure which is complicated in terms of structure and circuitry can be obtained.

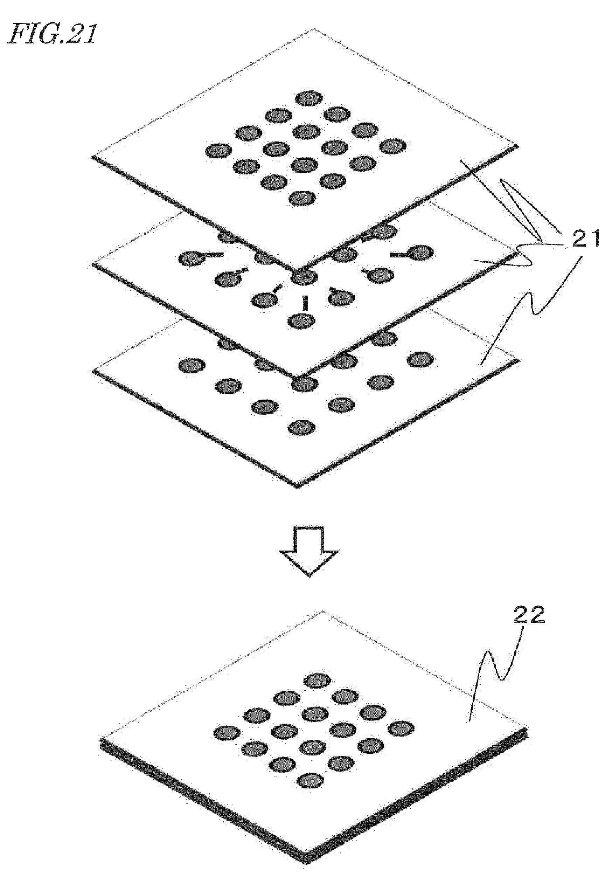

Next, as shown in FIG. **21****,** a plurality of green sheets **21** with electrodes, as are obtained by filling the electrode vias **16** of the green sheets **15** with the electrode material **18,** are stacked and laminated to form a laminated ceramic green sheet **22.** Herein, the stacking is performed so that a third green sheet is interposed between a first green sheet and a second green sheet. At this time, the plural green sheets **21** with electrodes are stacked so that, between adjacent green sheets **21** with electrodes, the electrodes on one sheet become electrically connected with the corresponding electrodes or circuit pattern for internal wiring on the other sheet. When stacking the green sheets **21** with electrodes, a jig, image recognition, or the like may be utilized to realize an accurate alignment of the electrode positions on the respective green sheets **21** with electrodes. For example, positioning throughholes may be provided in at least two places on the green sheets with electrodes, and a stacking jig which has pins in positions corresponding thereto may be provided. At stacking, the pins may be passed through the positioning throughholes formed in the green sheets with electrodes, thereby allowing the plurality of green sheets with electrodes to be positioned. In this method, however, the positioning throughholes in the green sheets with electrodes will have large diameters than the pin diameter. Therefore, generally, a higher positioning precision would be obtained by conducting the alignment by utilizing an image recognition function.

By laminating the plural green sheets **21** with electrodes into an integral piece, the laminated ceramic green sheet 22 is obtained. The green sheets **21** with electrodes can be laminated by using a hydraulic handpress, a uniaxial pressing machine, a CIP (cold isostatic pressing machine), or the like, for example. Use of a CIP would be advantageous because it will allow the green sheets **21** with electrodes to be laminated with a uniform pressure through isotropic pressurization.

Next, the laminated ceramic green sheet **22** is placed in a sintering furnace and fired. The temperature at firing is determined based on the material composition of the ceramic powder, which is to be chosen based on the composition of the electrode material **18.** For example, a ceramic material which can be sintered at about 900°C or less is selected when using Ag as the electrode material **18;** that which can be sintered at about 1000°C or less when using Au or Cu; and that which can be sintered at about 1400°C or less when using Ni or the like. Since Ag and Cu have low electrical resistance, the sizes of the top face electrodes **7,** the bottom face electrodes **9,** and the internal electrodes **8** (see FIG. **1**) can be reduced by choosing Ag or Cu as the electrode material **18.** Therefore, in the case where Ag or Cu is chosen as the electrode material **18,** an LTCC ceramic which can be simultaneously fired with the electrode material at 1000°C or less may be used as the ceramic powder material.

In an embodiment in the present disclosure, the laminated ceramic green sheet **22** is fired by using a zero shrinkage sintering process, where firing is carried out while suppressing changes in dimensions. The zero shrinkage sintering process used herein is a technique which involves laminating constraining layers onto the top face and the bottom face of the laminated ceramic green sheet in advance, the constraining layers being made of a material (e.g., Al₂O₃) which is not sintered at the firing temperature of the green sheets (which herein are the laminated ceramic green sheet **22**), and carrying out firing at the sintering temperature of the green sheets. By adopting a zero shrinkage sintering process, a sintered ceramic body is obtained such that contraction of the laminated ceramic green sheet **22** in any in-plane direction is kept to 1% or less. As the laminated ceramic green sheet **22** is fired, the electrode material **18** also becomes dense in texture concurrently with the firing of the LTCC material. Thus, the top face electrodes **7** and bottom face electrodes **9,** and the internal electrodes **8** providing electrically connection therebetween, are formed (see, for example FIG. **13**).

Firing of the laminated ceramic green sheet **22** is performed while the laminated ceramic green sheet **22** is disposed between members which are called setters, for example. It would be advantageous if the material composition of the setters contains as its main component a material that is contained as a main component in the green sheets to be fired. Herein, setters which are obtained by firing a material containing e.g. Al₂O₃, mullite, ZrO₂, or the like as a main component are used.

Herein, when firing the laminated ceramic green sheet **22,** the laminated ceramic green sheet **22** is placed on a setter, and a setter also is placed on the upper face of the laminated ceramic green sheet **22,** this setter being made of the same material as that of the setter on which the laminated ceramic green sheet **22** is placed. Thus, by carrying out firing while keeping the laminated ceramic green sheet **22** between the two setters which are made of the same material, the thermal profiles of the upper face and the lower face of the laminated ceramic green sheet **22** during the firing can be adjusted so as to be essentially identical. As a result, a temperature gradient between the upper face and the lower face of the laminated ceramic green sheet **22** can be reduced, whereby a sintered ceramic body with little warpage can be formed. Moreover, placing a setter on the upper face of the laminated ceramic green sheet **22** is expected to provide an effect of suppressing warpage during firing, due to weight of the setter. In a commonly-used firing process for ceramics, a green sheet will try to contract in in-plane directions of the sheet. Therefore, if a green sheet is straightforwardly fired with setters being disposed on the upper face and the lower face of the green sheet, partially-occurring friction between the green sheet and the setters will impede isotropic contraction of the green sheet, so that the resultant sintered body will have increased strain. On the other hand, under a zero shrinkage sintering process, the constraining layers provided on the upper and lower faces of the laminated ceramic green sheet **22** suppress contraction of the sheet in in-plane directions; therefore, even if firing is carried out with setters being in contact with the upper face and the lower face of the laminated ceramic green sheet **22,** a sintered ceramic body with little warpage can be obtained.

After firing, the constraining layers are removed, whereby a sintered ceramic body with reduced surface contraction and warpage is obtained. From the standpoint of ensuring that an SFQR of the multilayer ceramic substrate is equal to or less than 2 µm, it would be advantageous for the SFQR of the sintered ceramic body to be 50 µm or less and the amount of SORI to be 50 µm or less. By using a sintered ceramic body having SFQR and SORI in the above ranges, an efficient and inexpensive production can be achieved.

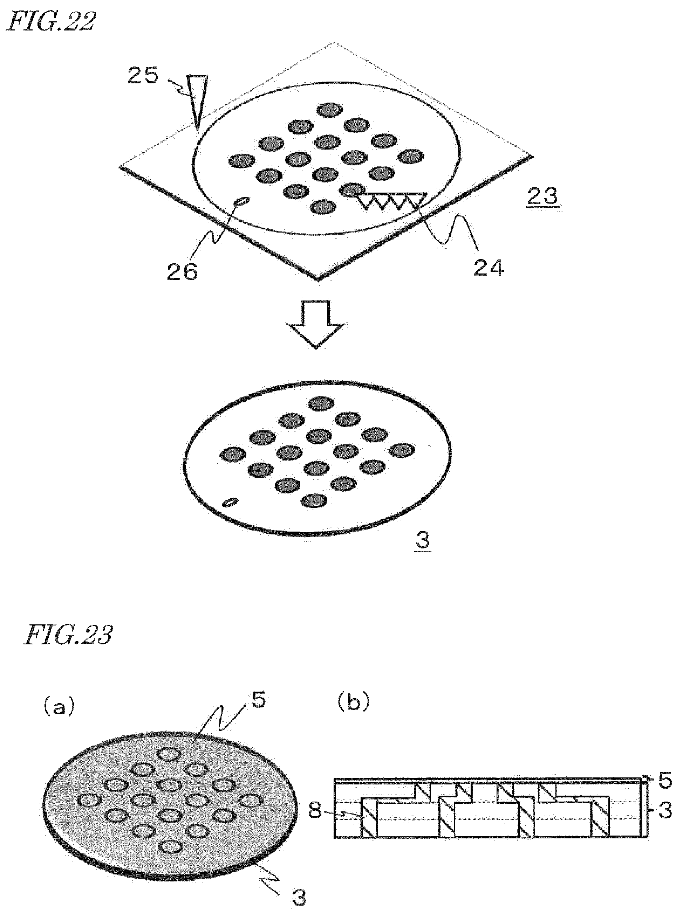

Next, as shown in FIG. **22****,** a grind and/or polish is performed as a planarization process for both faces of the sintered ceramic body **23.** This produces laminated ceramic having an SFQR equal to or less than 2 µm. The method of processing of the principal faces of the sintered ceramic body **23** may be selected as appropriate in accordance with the hardness of the sintered ceramic body **23.** For example, a grind or polish of the principal faces of the sintered ceramic body **23** can be performed by using abrasive grains **24.** After using a surface grinding or a polishing machine with abrasive grains of large diameters to apply coarse processing to the principal faces of the sintered ceramic body **23,** one face at a time, a polishing machine with abrasive grains of small diameters may be used to polish both principal face of the sintered ceramic body **23.** By performing coarse processing before polishing, SFQR can be made equal to or less than 2 µm in a relatively short time. The surface grinding may be performed for only one of the principal faces of the sintered ceramic body **23.** A further reduction in processing time would become possible with a double side lapping machine which is capable of simultaneous coarse processing of both faces. Furthermore, surface roughness can be reduced by utilizing CMP (Chemical Mechanical Polishing). It would be advantageous to reduce surface roughness, because it will reduce the thickness of the dielectric layer, which will be described later. Before or after performing a grind and/or polish for both faces of the sintered ceramic body **23,** the outer shape of the sintered ceramic body **23** may be processed into a desired shape. For example, by using a laser **25** or the like, the outer shape of the sintered ceramic body **23** may be made circular, and a notch, an orientation flat, or the like may be formed in the outer periphery of the sintered ceramic body **23.** Herein, the outer shape of the sintered ceramic body **23** is made circular to give a multilayer ceramic substrate **3** of a disk shape. Also, as shown in FIG. **22****,** an identification mark **26** may be provided on the sintered ceramic body **23** by using a laser or the like. The outer shape, the presence or absence of the identification mark **26,** and the like of the multilayer ceramic substrate **3** can be arbitrarily selected in accordance with specifications of an apparatus to be used in the photolithography of a subsequent step.

Through the above steps, the multilayer ceramic substrate **3** is obtained, such that a plurality of electrodes (top face electrodes and bottom face electrode) are provided on the top face and the bottom face of the substrate, the top face electrodes and the bottom face electrodes being electrically connected by way of the internal electrodes. In the multilayer ceramic substrate **3** as zoned into a plurality of evaluation regions by the units of 20 mm x 20 mm, an SFQR in a 20 mm x 20 mm evaluation region is equal to or less than 2 µm in at least 50% of the plurality of evaluation regions. Note that the evaluation regions are typically defined on the top face of the multilayer ceramic substrate **3,** excluding 1 mm from its outer periphery. The multilayer ceramic substrate **3** which is obtained through the above steps accepts photolithography using a stepper, because, as zoned into a plurality of evaluation regions by the units of 20 mm x 20 mm, its SFQR is equal to or less than 2 µm in at least 50% of the evaluation regions. Therefore, it is possible to form a fine line pattern of any arbitrary design on the top face of the multilayer ceramic substrate.

Hereinafter, an exemplary method of forming a wiring pattern on the top face of the multilayer ceramic substrate 3 will be described. Herein, a method which utilizes photolithography and electroplating to form a wiring pattern will be described. Hereinafter, a structure having a dielectric layer between the top face of the multilayer ceramic substrate **3** and the wiring pattern will be illustrated. First, as shown in FIG. **23(a)** and FIG. **23(b)****,** a dielectric layer **5** is formed on the top face of the multilayer ceramic substrate **3.** For example, by a spin coating technique, a dip coating technique, a spray coating technique, or the like, a film of polyimide, siloxane-type polymer, or the like is formed on the top face of the multilayer ceramic substrate **3.** By proving a liquid material to the top face of the multilayer ceramic substrate **3,** a film with a flat surface that does not follow along the minute ruggednesses of the top face of the multilayer ceramic substrate **3** can be formed. By applying the liquid material by a spin coating technique, for example, a film having an essentially uniform thickness is formed on the top face of the multilayer ceramic substrate **3.** Therefore, the planarity of the film formed on the top face of the multilayer ceramic substrate 3 reflects the planarity of the top face of the multilayer ceramic substrate **3.** Alternatively, an organic dielectric film such as an SiO₂ film may be formed by applying a sputtering technique, a CVD (Chemical Vapor Deposition) technique, or the like. In this case, too, a film having an essentially uniform thickness can be formed on the top face of the multilayer ceramic substrate **3.** Therefore, in the case of forming an organic dielectric film, too, the planarity of the film formed on the top face of the multilayer ceramic substrate **3** reflects the planarity of the top face of the multilayer ceramic substrate **3.**

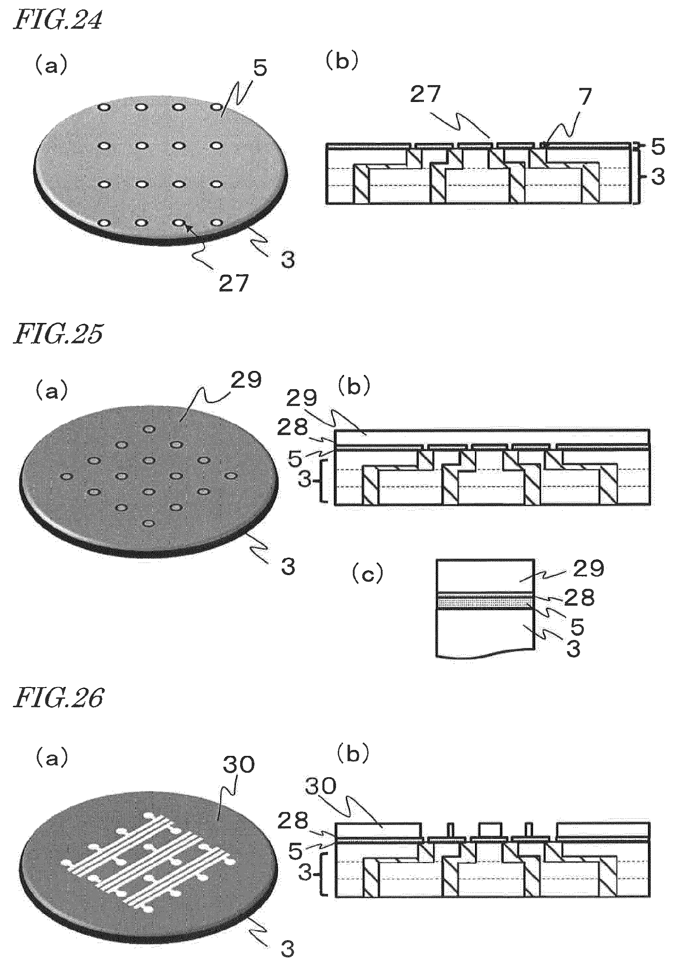

Next, as shown in FIG. **24(a)** and FIG. **24(b)****,** portions of the dielectric layer **5** are removed to form throughholes **27** in the dielectric layer **5.** By forming the throughholes **27,** at least a portion of each top face electrode **7** is revealed. In the case where the dielectric layer **5** is made of polyimide, the throughholes **27** can be formed by forming a photoresist pattern for the throughholes on the dielectric layer **5** through photolithography, and etching the polyimide film by using a chemical etchant or the like. In the case where a film of a photo-sensitive polyimide or the like is formed on the multilayer ceramic substrate **3,** the throughholes **27** can be formed by removing unnecessary portions after exposure of the film on the multilayer ceramic substrate **3.** In the case where an inorganic material is deposited on the multilayer ceramic substrate **3,** the throughholes **27** can be formed by forming a photoresist pattern through photolithography, and thereafter applying wet etching using a buffered hydrofluoric acid, or plasma-based dry etching by using a gas that contains a fluoride such as carbon tetrafluoride, and so on.

The throughholes **27** are formed so as to be aligned with the top face electrodes **7** of the multilayer ceramic substrate **3.** As a result, by way of the throughholes **27,** each top face electrode **7** of the multilayer ceramic substrate **3** can be electrically connected with a wiring pattern described below. In the illustrative production method described herein, the throughholes **27** are formed by using a photolithography technique. At this time, for example, the positions of the top face electrodes **7** of the multilayer ceramic substrate **3** are confirmed through visual inspection- or image recognition-based detection, and a mask for forming the throughholes are aligned with respect to the positions of the top face electrodes **7.** An alignment pattern or the like may be previously formed on the multilayer ceramic substrate **3.** Thus, an arbitrary pattern which is formed in advance may also be available for alignment. As described earlier, in an embodiment in the present disclosure, the multilayer ceramic substrate **3** is produced by adopting a zero shrinkage sintering process which is able to control contraction in in-plane directions. Therefore, the deviations in position from target positions (i.e., reference positions by design) of the top face electrodes **7** are small enough for photolithography to be applicable to the formation of the throughholes **27.**

Next, a wiring pattern is formed on the upper face of the dielectric layer **5.** It would be advantageous to form the wiring pattern by using a low-resistivity material including Al, Cu, or the like, because the electrical resistance of the wiring pattern can be reduced. It would also be advantageous to increase the film thickness of the wiring pattern as much as possible to ensure that the wiring pattern has a large cross-sectional area, because the electrical resistance of the wiring pattern can be reduced. As a simple method of forming the wiring pattern, a method of forming a Cu film by adopting an electroplating technique is known. With an electroplating technique, a plating layer can be selectively grown in a region in which a seed layer is formed. Moreover, it is possible to adjust the growth rate of the plating layer through current density adjustments.

When forming the wiring pattern, first, as shown in FIG. **25(b)** and FIG. **25(c),** a metal base film **28** is formed by e.g. a sputtering technique on the dielectric layer **5.** The metal base film **28** may be a two-layered film in which, for example, a Cr film with a film thickness of 0.02 µm is formed and further a Cu film with a film thickness of 0.08 µ m is formed on its surface. By forming the Cr film or Ti film so as to be in contact with the dielectric layer **5,** adhesivity of the metal base film **28** with respect to the dielectric layer **5** can be improved. The metal base film **28** functions as a feeding layer to supply a necessary current during electroplating. The composition and structure of the metal base film **28** are not limited to the above example. After forming the metal base film **28,** as shown in FIG. **25(a)** to FIG. **25(c)**, a photoresist **29** is applied on the metal base film **28.** The method of applying the photoresist **29** may be a spin coating technique, a dip coating technique, a spray coating technique, a slit coating technique, or the like. The method of applying the photoresist **29** may be selected as appropriate, in accordance with the viscosity of the photoresist, the dimensions of the multilayer ceramic substrate 3, and so on. Generally, a spin coating technique is used for the application of the photoresist. The film thickness of the photoresist **29** is set to a thickness which is greater than the thickness of the plating film to be formed. If the photoresist **29** is thinner than the plating film, a plating film may be formed astride the pattern of the photoresist **29,** thereby allowing adjacent wires in the wiring pattern to become short-circuited. For example, in the case of forming a plating film having a thickness of 2.0 µm, a photoresist having a thickness of about 2.2 to about 2.6 µm may be formed.

Next, through exposure and development of the photoresist **29,** unnecessary portions of the photoresist **29** are removed, whereby a photoresist pattern **30** is formed (see FIG. **26(a)** and FIG. **26(b)**). In the exposure of the photoresist **29,** an exposure apparatus is selected in accordance with the required resolution. For example, if the line width in the wiring pattern to be formed is 1 µm to 2 µm, a reduction projector (stepper) having a light source which emits the g-line (wavelength: 436 nm), the h-line (wavelength: 405 nm), or the i-line (wavelength: 365 nm) may be used. In the stepper, a light beam which is emitted from the light source is converged by lenses, whereby an image of a photomask pattern converges on the photoresist **29.** The resolution of the photoresist pattern **30** depends on the degree of defocus at this time.

FIG. **33** is referred to again. In the graph shown in FIG. **33****,** data are plotted concerning samples in the case where a Cr film (film thickness: 0.02 µm) and a Cu film (film thickness: 0.08 µm) are consecutively formed on a silicon substrate by a sputtering technique, a positive type photoresist is applied by a spin coating technique, and then exposure is performed with an i-line stepper. An alkaline developer was used for the development of the photoresist, where development was carried out for 120 seconds by a paddle method.

In the graph of FIG. **33****,** the horizontal axis represents an amount of deviation from the optimum focus value. The amount of deviation is indicated by signs such that, any upper deviation of the focus position reads positive and any lower deviation of the focus position reads negative, where the face of the substrate that is subjected to exposure is supposed to be upward. The vertical axis (photoresist dimension) in the graph represents the width (line interval) of each portion from which photoresist is removed in an essential center of the shot; this photoresist dimension corresponds to the width of a wire to be subsequently formed. It can be seen from FIG. **33** that the line width increases as the focus deviates from the optimum value. When the amount of deviation from the optimum value is -1 µm or less or +1 µm or more, the photoresist pattern fails (see FIG. **34**) so that the line width becomes too broad. Therefore, from the standpoint of obtaining a photoresist pattern with a line width (line width) or a line interval of about 2 µm, it would be advantageous if the amount of deviation from the optimum focus value is within a range of 2 µm (within a range of ± 1 µm from the optimum focus value).

The stepper repeatedly performs exposure based on a constant unit range (shot), thus achieving exposure for the entire photoresist. A shot is typically a region of about 10 mm x 10 mm to about a 20 mm x 20 mm. Generally, prior to exposure on a shot-to-shot basis, a stepper takes height measurements of the substrate surface inside the apparatus. As a result of this, it calculates a focus reference plane for each shot, and performs an exposure operation. Therefore, it can be said that defocus will not occur if exposure is to be performed for a photoresist on an ideal substrate which is free of any surface height variation. However, in actuality, a substrate having a photoresist provided thereon will have some variations in surface height. A surface height to be measured for each shot is supposed to be a representative value of the surface height for that shot; even if a stepper can correct for surface height variations between shots, it cannot correct for surface height variations within a shot. Therefore, if there are variations in surface height within a shot, defocus may occur partially within the shot. Out-of-focusness within a shot may cause a decrease in the resolution of the photoresist pattern.

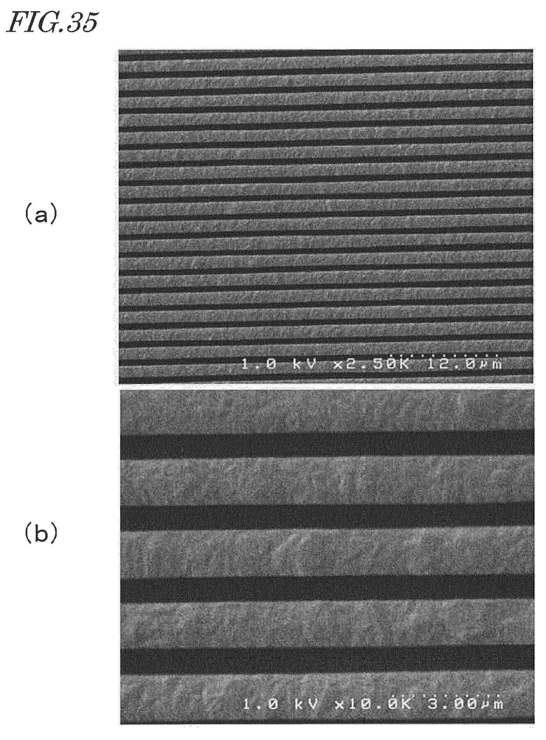

As can be seen from FIG. **33****,** by keeping the height variations within a shot to within 2 µm during exposure, it becomes possible to form minute wires as shown in FIG. **35****.** The exact specifications that are required of a substrate on which to form the wiring pattern **6** will depend on the functions possessed by the exposure apparatus. For example, in the case of a stepper having a mechanism to correct inclination of a substrate, it is preferable that SFQR be equal to or less than 2 µm. In the case of a stepper not having a mechanism to correct inclination of a substrate, it is preferable that SBIR be equal to or less than 2 µm. In the case of an aligner which applies universal exposure to the entire substrate surface (e.g., a contact aligner), it is preferable that GBIR be equal to or less than 2 µm.

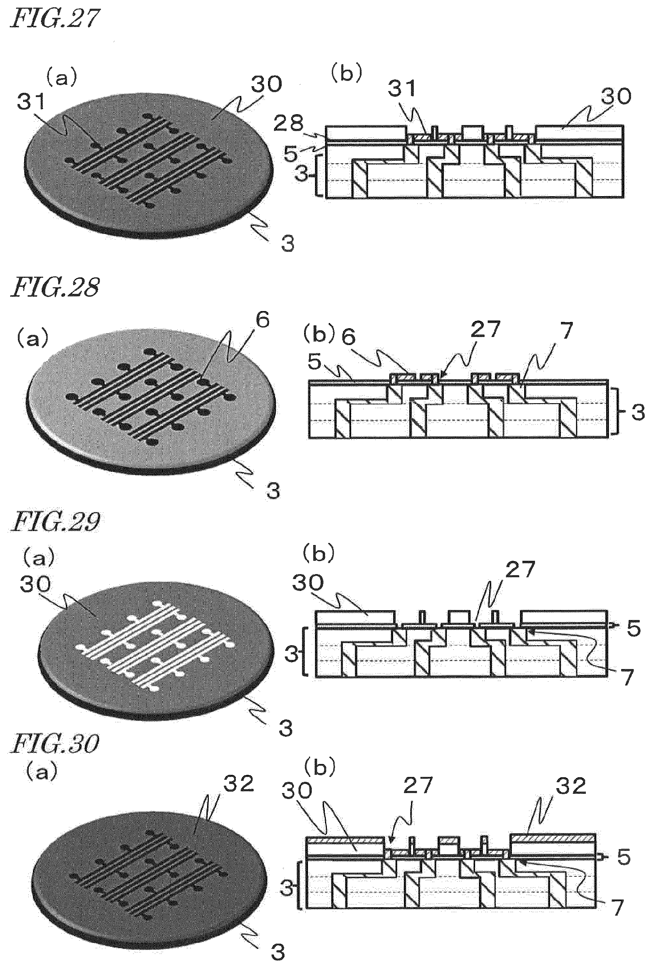

Next, by an electroplating technique, as shown in FIG. **27(a)** and FIG. **27(b)****,** a plating layer **31** is allowed to deposit on the metal base film **28.** As a result, the wiring pattern **6** can be selectively formed in regions where photoresist is absent. Examples of metals to compose the plating layer **31** include Cu, Ag, Au, Ni, Al, etc., which are low in electrical resistance. It would be advantageous if the surface of the metal base film **28** is of the same metal as the metal composing the plating layer **31,** because adhesivity of the plating layer **31** with the metal base film **28** can be enhanced.

Next, the photoresist pattern **30** is removed by a known method. Thereafter, the metal base film **28** in any region other than the regions in which the plating layer **31** is formed is removed by a known method (see FIG. **28(a)** and FIG. **28(b)**). As a result, the wiring pattern **6** is obtained on the surface on which the top face electrodes **7** of the multilayer ceramic substrate **3** exist. As shown in FIG. **28(b)****,** the wiring pattern **6** is electrically connected with the top face electrodes **7** by way of the throughholes **27** in the dielectric layer **5.**

Through the above steps, the wafer for mounting substrates **1** as shown in FIG. **11** is obtained.

### [second embodiment]

The wiring pattern **6** on the multilayer ceramic substrate **3** may be formed by a vacuum film deposition technique.

The multilayer ceramic substrate 3 can be obtained in a similar manner to the first embodiment. Therefore, description of the steps for producing the multilayer ceramic substrate **3** will be omitted herein. In the second embodiment, too, the multilayer ceramic substrate **3** is structured so that a plurality of electrodes (top face electrodes and bottom face electrode) are provided on the top face and the bottom face thereof, the top face electrodes and the bottom face electrodes being electrically connected by way of the internal electrodes. The multilayer ceramic substrate used herein includes regions such that an SFQR in a 20 mm x 20 mm evaluation region is equal to or less than 2 µ m, on the top face excluding 1 mm from its outer periphery. Hereinafter, a step of forming the wiring pattern **6** through photolithography will be described.

First, as the dielectric layer **5,** a resin layer such as polyimide or an inorganic material layer or the like is formed on the top face of the multilayer ceramic substrate **3.** Thereafter, throughholes **27** are formed in the dielectric layer **5.** Next, a photoresist is applied on the dielectric layer **5** and over the throughholes **27.** At this time, the thickness of the photoresist is adjusted so as to be thicker than the thickness of the wiring pattern to be formed. Next, the photoresist is subjected to exposure and development by using e.g. a stepper, thus removing unnecessary portions of the photoresist. Thus, as shown in FIG. **29(a)** and FIG. **29(b)****,** a photoresist pattern **30** is formed on the dielectric layer **5.**

Then, as shown in FIG. **30(a)** and FIG. **30(b)****,** a metal layer **32** is formed on the photoresist pattern **30** by using a vacuum film deposition technique. Examples of vacuum film deposition techniques include a sputtering technique and a vacuum evaporation technique. Examples of metals to be deposited on the photoresist pattern **30** include Cu, Ag, Au, Ni, Al, etc., which are low in electrical resistance. As shown in FIG. **30(b)****,** the metal layer **32** is formed not only on the photoresist, but also on the dielectric layer **5** and at portions of the top face electrodes **7** that overlap the throughholes **27.**

Next, the photoresist pattern **30** is removed by a known method (see FIG. **31(a)** and FIG. **31(b)**). At this time, together with the photoresist pattern **30,** any metal of the metal layer **32** that exists on the photoresist pattern **30** is removed (lift-off). In other words, the metal is left only in the regions which were not masked by the photoresist pattern **30.** As a result, the wiring pattern **6** is formed. According to the production method of the second embodiment, an electrolyte and the like that are required for electroplating are not needed; therefore, as compared to the case of adopting an electroplating technique, more choices are available as the metal to compose the wiring pattern **6.**

### [third embodiment]

FIG. **32** shows a cross section of a mounting substrate according to a third embodiment. The mounting substrate **4a** shown in FIG. **32** includes a dielectric layer **5** between a top face **3x** of a ceramic chip substrate **300** and a wiring pattern **6.** Moreover, the mounting substrate **4a** includes bump electrodes **13** on the wiring pattern **6.** The mounting substrate **4a** can be produced by, for example, forming the bump electrodes **13** on the wiring pattern **6** of a wafer for mounting substrates which is obtained by the method described in the first or second embodiment, and thereafter cutting and splitting the wafer for mounting substrates. Note that the bump electrodes **13** may be formed after cutting and splitting the wafer for mounting substrates.

The bump electrodes **13** may have a multilayer structure composed of a plurality of metal layers. Herein, by using photolithography, electrode pads of an Ni/Au multilayer structure are formed at places of the wiring pattern **6** of the wafer for mounting substrates at which the bump electrodes **13** are to be formed. Before forming the electrode pads, a protection layer for the wiring pattern may be provided in regions other than the places where the bump electrodes **13** are to be formed. This protection layer is made of an electrically insulative material. Next, an Sn layer is formed on the electrode pads. As a result, bump electrodes are provided which can realize physical and electrical connection between the electrodes of a semiconductor chip(s) (e.g., Cu electrodes) and the wiring pattern **6.** The Sn layer can be efficiently formed if the Sn layer has the same pattern as that of the mask used for forming the electrode pads. The method of forming the Sn layer is not limited to any particular methods, and an electroplating technique, a sputtering technique, or the like can be used, for example. It would be advantageous if the Sn layer has a thickness of about 15 µm, because a sufficient bonding strength with respect to the semiconductor chip(s) is obtained. From the standpoint of allowing Sn to deposit to a thickness of 15 µm, it would be useful to adopt an electroplating technique for the formation of the Sn layer.

Now, the material and production method for the green sheets to be used for forming the multilayer ceramic substrate will be described in outline. As the green sheet material, a ceramic material which accounts for the melting point(s) of the material(s) of the electrodes to be formed on the multilayer ceramic substrate are used. For example, a mixture containing any of various oxides of Al, Si, Sr, and Ti as a main component and at least one or more of various oxides of Bi, Na, K, and Co and at least one or more of various oxides of Cu, Mn, and Ag as sub-components, as well as other inevitable impurities, is calcined at 700°C to 850°C; and this is pulverized to obtain fine-pulverized particles with an average particle size of 0.6 to 2 µm. A slurry obtained by adding to these resultant fine-pulverized particles various additives such as an organic binder, a plasticizer, and/or a solvent is shaped into a sheet form by a doctor blade technique or the like, whereby a green sheet is obtained. When a ceramic material of low contraction is used, changes in dimensions and shape during firing, etc., can be suppressed. Use of a ceramic material which is capable of forming a sintered body having a coefficient of thermal expansion close to that of Si would be advantageous because it can reduce difference in thermal expansion between the semiconductor chip(s) and the ceramic chip substrate. By reducing the difference in thermal expansion between the semiconductor chip(s) and the ceramic chip substrate, influences of warpage, etc., as caused by difference in thermal expansion due to a heat treatment during the mounting of a semiconductor chip, can be suppressed.

As will be clear from the foregoing description, according to the present disclosure, internal electrodes and/or a circuit pattern for internal wiring can be easily formed in a process of producing a multilayer ceramic substrate. Therefore, by using a ceramic material which can realize a high dielectric constant in forming a green sheet, for example, circuitry with an internalized capacitor function can be created in the interior of the multilayer ceramic substrate. Moreover, for example, a material having varistor characteristics may be used as the ceramic material. This will allow the circuitry which is formed in the interior of the multilayer ceramic substrate to have a function of overcurrent prevention. Furthermore, by using a material with high thermal conductivity, the heat which has occurred in a semiconductor chip and the like can be dissipated to the multilayer ceramic substrate.

### (Example 1)

By using a similar method to the production method described in the first embodiment, a wafer for mounting substrates, having a diameter of 150 mm, was produced. The planarization process for the sintered ceramic body was performed while the surface to be processed, i.e., of the top-face ceramic layer or the bottom-face ceramic layer, was placed directly on a faceplate for polishing, so that the substrate would not be deformed. Utilizing the surface to be processed (e.g., the top face) itself as a reference plane of polishing makes it possible to prevent the surface to be processed from being affected by substrate ruggednesses, foreign matter such as adhesive, or lodging of particles originating from the polishing step; thus, planarity of the surface to be processed after processing is improved. The resultant multilayer ceramic substrate was zoned into 20 mm x 20 mm evaluation regions to measure SFQR; the results are shown in Table 1.

The resultant multilayer ceramic substrate attained an SFQR being equal to or less than 2 µ m in 100% of the plurality of evaluation regions, and an SFQR of 1 µ m or less in 97%. The chip area size in each wafer for mounting substrates was 15 mm ×15 mm, and 60 chip areas were formed in one wafer. As a photoresist for forming a wiring pattern, a positive type photoresist THMR-iP5700 (viscosity: 0.025 Pa· s) manufactured by TOKYO OHKA KOGYO CO., LTD. was used. A spin coating technique (revolution: 3000 rpm) was used in applying the photoresist. The photoresist had a thickness of 2.3 µ m. For exposure of the photoresist, an i-line stepper NSR-2205i12 manufactured by Nikon was used. The pitch of lines in a photomask for forming a photoresist pattern was 2 µm.

### (Example 2)

A wafer for mounting substrates was produced under the same conditions as in Example 1 except that, in the planarization process of the sintered ceramic body, one face (e.g., the bottom face) was immobilized on a flat face (e.g., a lapping machine) by applying load and the surface to be processed (e.g., the top face) was polished. Results of measuring SFQR by zoning the multilayer ceramic substrate into 20 mm x 20 mm evaluation regions are shown in Table 1. The resultant multilayer ceramic substrate attained an SFQR being equal to or less than 2 µm in 78% of the plurality of evaluation regions, and an SFQR of 1 µm or less in 59%.

**[Table 1]**

| | SFQR | | | ratio of those equal to or less than 2 *µ*m |
|---|---|---|---|---|
| | 1 *µ*m or less | above 1 *µ*m, equal to or less than 2 *µ*m | above 2 *µ*m | |
| Example 1 | 97% | 3% | 0% | 100% |
| Example 2 | 59% | 19% | 22% | 78% |

### (Example 3)

By using a similar method to that of Example 1, two wafers for mounting substrates were produced, and cutting and splitting was performed in accordance with the chip areas to obtain a plurality of cut pieces. Among the resultant cut pieces, those cut pieces in which SFQR of the ceramic chip substrate was equal to or less than 2 µm were extracted, and these were designated as mounting substrates of Example 3. In one of the wafers for mounting substrates, SFQR of the ceramic chip substrate was equal to or less than 2 µm in sixty of the 60 cut pieces which were cut out. In the other wafer for mounting substrates, SFQR of the ceramic chip substrate was equal to or less than 2 µm in fifty-four of the 60 cut pieces which were cut out. An wiring pattern was formed which had a line width of 0.5 to 1.5 µm, with a line interval of 0.5 to 1.5 µm.

Table 2 shows results of checking the wiring pattern on the mounting substrates of Example 3. As shown in Table 2, in all of the mounting substrate of Example 3, a minimum line width being equal to or less than 2 µ m was attained. Moreover, the minimum line space was greater than 0 µm and equal to or less than 2 µm.

### (Comparative Example 1)

Among the cut pieces obtained by cutting and splitting the wafers for mounting substrates in accordance with chip areas, those cut pieces in which SFQR of the ceramic chip substrate was greater than 2 µm were extracted, and these were designated as mounting substrates of Comparative Example 1. Table 2 shows results of checking the wiring pattern on the mounting substrates of Comparative Example 1. In all of the mounting substrates of Comparative Example 1, it was at least the case that the minimum line width was greater than 2 µm or that the minimum line space was below 0 µm. In other words, wiring pattern failures had occurred.

**[Table 2]**

| | SFQR | number of mounting substrates produced | wiring pattern failure | pass rate |
|---|---|---|---|---|
| Example 3 | equal to or less than 2 *µ*m | 114 substrates | 0 substrates | 100% |
| Comparative Example 1 | above 2 *µ*m | 6 substrates | 6 substrates | 0% |

According to a study by the inventors, as was described with reference to FIG. **33**, it can be said that there is at least 1 µm of defocus within the shot when SFQR of the substrate is greater than 2 µm. In other words, a pattern failure has possibly occurred within the shot if SFQR of the substrate is greater than 2 µm. As is understood from this finding, SFQR of the mounting substrate being greater than 2 µm indicates a high possibility that at least ± 1 µm of defocus occurred during exposure of the photoresist. From the results shown in Table 2, it is considered that a pattern failure in the wiring pattern exists when SFQR of the mounting substrate is greater than 2 µm.

### (Example 4)

A mounting substrate of Example 4 was produced in a similar manner to Example 1, except that exposure was performed without correcting inclination of the substrate by using a stepper (NSR-2205i12, manufactured by NIKON). In the resultant wafer for mounting substrates, it was confirmed that SBIR was equal to or less than 2 µm in at least 50% or more of the evaluation regions. Moreover, the minimum line space in the wiring pattern which was formed on the mounting substrate was greater than 0 µm and equal to or less than 2 µm, with a minimum line width which was equal to or less than 2 µm.

### (Example 5)

A mounting substrate of Example 5 was produced in a similar manner to Example 1, except that universal exposure was performed by using an aligner (MA-6, manufactured by SUSS) instead of a stepper. In the resultant wafer for mounting substrates, it was confirmed that GBIR was equal to or less than 2 µm. Moreover, the minimum line space in the wiring pattern which was formed on the mounting substrate was greater than 0 µm and equal to or less than 2 µm, with a minimum line width which was equal to or less than 2 µ m.

### INDUSTRIAL APPLICABILITY

According to embodiments in the present disclosure, a mounting substrate which facilitates mounting of semiconductor chips having a high degree of integration onto a main substrate or the like, and a wafer for mounting substrates, from which to produce the mounting substrate, are provided. Embodiments in the present disclosure are applicable to interposers which can be used in the fabrication of semiconductor packages, mobile appliance circuitry, and the like, for example.

### REFERENCE SIGNS LIST

**1**···wafer for mounting substrates
**2**···chip area
**3**···multilayer ceramic substrate
**4**···mounting substrate
**5**···dielectric layer
**6**···wiring pattern
**7**···top face electrode
**s1**···minimum line width
**p1**···minimum line space
8**·**··internal electrode
**9**···bottom face electrode
**12**···reference plane
**t1**···bump electrode height
**p2**···bump electrode pitch
**13**···bump electrodes
**14**···global best-fit reference plane in a non-sucked state
**15**···green sheet
**16**···electrode via
**17**···laser
**18**···electrode material
**19**···mask
**20**···squeegee
**21**···green sheet with electrodes
**22**···laminated ceramic green sheet
**23**···sintered ceramic body
**24**···abrasive grain
**25**···laser
**26**···identification mark
**27**···throughhole
**28**···metal base film
**29**···photoresist
**30**···photoresist pattern
**31**···plating layer
**32**···metal layer
**300**···ceramic chip substrate

## Claims

1. A wafer for mounting substrates, comprising:
a multilayer ceramic substrate having a top face and a bottom face and including: a top-face ceramic layer located at the top face; a bottom-face ceramic layer located at the bottom face; a plurality of top face electrodes extending through the top-face ceramic layer, a plurality of bottom face electrodes extending through the bottom-face ceramic layer; and an intermediate ceramic layer having a plurality of internal electrodes formed therein, the plurality of internal electrodes being internal to the multilayer ceramic substrate and providing electrical connection between the plurality of top face electrodes and the plurality of bottom face electrodes; and
a wiring pattern formed on the top face of the multilayer ceramic substrate, the wiring pattern having a minimum line width which is equal to or less than 2 µm and a minimum line space which is equal to or less than 2 µm, wherein,
an inter-electrode-central distance of the plurality of top face electrodes is smaller than an inter-electrode-central distance of the plurality of bottom face electrodes; and
the top face of the multilayer ceramic substrate, when zoned into a plurality of evaluation regions by the units of 20 mm x 20 mm, is planarized so that SFQR (Site Front Least Squares Ranges) in a 20 mm x 20 mm evaluation region is equal to or less than 2 µm in at least 50% of the plurality of evaluation regions.

2. The wafer for mounting substrates of claim 1, wherein the top face of the multilayer ceramic substrate, when zoned into a plurality of evaluation regions by the units of 20 mm x 20 mm, is planarized so that SBIR (Site Back Surface Referenced Ideal Ranges) in a 20 mm x 20 mm region is equal to or less than 2 µm in at least 50% of the plurality of evaluation regions.

3. The wafer for mounting substrates of claim 1 or 2, wherein the top face of the multilayer ceramic substrate is planarized so that GBIR (Global Back Ideal Ranges) is equal to or less than 2 µ m.

4. The wafer for mounting substrates of any of claims 1 to 3, comprising a dielectric layer between the top face of the multilayer ceramic substrate and the wiring pattern, wherein,
the dielectric layer has a plurality of holes for electrically connecting each of the plurality of top face electrodes to the wiring pattern; and
the plurality of top face electrodes are respectively aligned with the plurality of holes.

5. The wafer for mounting substrates of claim 4, wherein a distance from a center position of each of the plurality of top face electrodes to a center position of a corresponding one of the plurality of holes is equal to or less than a radius of the top face electrode.

6. The wafer for mounting substrates of claim 4 or 5, wherein positions of the plurality of holes are defined through a photolithography step.

7. The wafer for mounting substrates of any of claims 1 to 6, wherein positions of the plurality of wiring patterns are defined through a photolithography step.

8. A multilayer ceramic substrate for the wafer for mounting substrates of any of claims 1 to 7,
the multilayer ceramic substrate having a top face and a bottom face,
the multilayer ceramic substrate comprising:
a top-face ceramic layer located at the top face;
a bottom-face ceramic layer located at the bottom face;
a plurality of top face electrodes extending through the top-face ceramic layer;
a plurality of bottom face electrodes extending through the bottom-face ceramic layer; and
an intermediate ceramic layer having a plurality of internal electrodes formed therein, the plurality of internal electrodes providing electrical connection between the plurality of top face electrodes and the plurality of bottom face electrodes, wherein,
an inter-electrode-central distance of the plurality of top face electrodes is smaller than an inter-electrode-central distance of the plurality of bottom face electrodes; and
the top face of the multilayer ceramic substrate, when zoned into a plurality of evaluation regions by the units of 20 mm x 20 mm, is planarized so that SFQR (Site Front Least Squares Ranges) in a 20 mm x 20 mm region is equal to or less than 2 µm in at least 50% of the plurality of evaluation regions.

9. A mounting substrate for a semiconductor chip to be mounted thereon, comprising:
a ceramic chip substrate including a top-face ceramic layer located at a top face, a bottom-face ceramic layer located at a bottom face, a plurality of top face electrodes extending through the top-face ceramic layer, a plurality of bottom face electrodes extending through the bottom-face ceramic layer, and an intermediate ceramic layer having a plurality of internal electrodes formed therein, the plurality of internal electrodes being internal to the multilayer ceramic substrate and providing electrical connection between the plurality of top face electrodes and the plurality of bottom face electrodes; and
a wiring pattern formed on the top face of the ceramic chip substrate, the wiring pattern having a minimum line width which is equal to or less than 2 µm and a minimum line space which is equal to or less than 2 µm, wherein,
an inter-electrode-central distance of the plurality of top face electrodes is smaller than an inter-electrode-central distance of the plurality of bottom face electrodes; and
the top face of the ceramic chip substrate is planarized so that SFQR (Site Front Least Squares Ranges) in a 20 mm x 20 mm region is equal to or less than 2 µm.

10. The mounting substrate of claim 9, wherein the top face of the ceramic chip substrate is planarized so that SBIR (Site Back Surface Referenced Ideal Ranges) in a 20 mm x 20 mm region is equal to or less than 2 µm.

11. The mounting substrate of claim 9 or 10, comprising a plurality of bump electrodes formed on the wiring pattern.

12. The mounting substrate of any of claims 9 to 11, wherein an inter-electrode-central distance of the plurality of bump electrodes is 1/10 or less of the inter-electrode-central distance of the bottom face electrodes.

13. The mounting substrate of any of claims 9 to 12, comprising a dielectric layer between the top face of the ceramic chip substrate and the wiring pattern, wherein,
the dielectric layer has a plurality of holes for electrically connecting each of the plurality of top face electrodes to the wiring pattern; and
the plurality of top face electrodes are respectively aligned with the plurality of holes.

14. The mounting substrate of claim 13, wherein a distance from a center position of each of the plurality of top face electrodes to a center position of a corresponding one of the plurality of holes is equal to or less than a radius of the top face electrode.

15. The mounting substrate of claim 13 or 14, wherein positions of the plurality of holes are defined through a photolithography step.

16. The mounting substrate of any of claims 9 to 15, wherein positions of the plurality of wiring patterns are defined through a photolithography step.

17. A mounting substrate having been individually cut out from the wafer for mounting substrates of any of claims 1 to 7,
comprising a plurality of bump electrodes formed on the wiring pattern.

18. The mounting substrate of claim 17, wherein an inter-electrode-central distance of the plurality of bump electrodes is 1/10 or less of the inter-electrode-central distance of the bottom face electrodes.

19. A chip module comprising:
the mounting substrate of any of claims 9 to 18; and
a plurality of semiconductor chips mounted on the mounting substrate.

20. A method of producing a wafer for mounting substrates, comprising:
a step of providing a multilayer ceramic substrate including a top-face ceramic layer located at a top face, a bottom-face ceramic layer located at a bottom face, a plurality of top face electrodes extending through the top-face ceramic layer, a plurality of bottom face electrodes extending through the bottom-face ceramic layer, and an intermediate ceramic layer having a plurality of internal electrodes formed therein, the plurality of internal electrodes being internal to the multilayer ceramic substrate and providing electrical connection between the plurality of top face electrodes and the plurality of bottom face electrodes, wherein an inter-electrode-central distance of the plurality of top face electrodes is smaller than an inter-electrode-central distance of the plurality of bottom face electrodes;
a step of applying a planarization process to at least the top face of the multilayer ceramic substrate so that, when the multilayer ceramic substrate is zoned into a plurality of evaluation regions by the units of 20 mm x 20 mm, SFQR (Site Front Least Squares Ranges) in a 20 mm x 20 mm evaluation region is equal to or less than 2 µm in at least 50% of the plurality of evaluation regions; and
a step of forming a wiring pattern on the top face of the multilayer ceramic substrate through photolithography, the wiring pattern having a minimum line width which is equal to or less than 2 µ m and a minimum line space which is equal to or less than 2 µm; wherein,
the step of providing the multilayer ceramic substrate comprises:
a step of providing a first green sheet to compose the top-face ceramic layer and a second green sheet to compose the bottom-face ceramic layer;
a step of subjecting the first and second green sheets to aging;
a step of, after the aging treatment, forming a plurality of holes defining the plurality of top face electrodes and the plurality of bottom face electrodes in the first and second green sheets;
a step of providing at least one third green sheet to compose at least one ceramic layer located between the top-face ceramic layer and the bottom-face ceramic layer;
a step of forming a plurality of holes defining the plurality of internal electrodes in the third green sheet;
a step of filling the plurality of holes of the first, second, and third green sheets with an electrically conductive material;
a step of stacking and laminating the first, second, and third green sheets to form a laminated ceramic green sheet; and
a step of firing the laminated ceramic green sheet to form a sintered ceramic body, the sintered ceramic body including internal electrodes to connect a top face and a bottom face, top face electrodes, and bottom face electrodes.

21. The method of producing a wafer for mounting substrates of claim 20, wherein before and after the step of firing the laminated ceramic green sheet, the multilayer ceramic substrate contracts by a distance of 1% or less along any in-plane direction.

22. A method of producing a wafer for mounting substrates, comprising:
a step of forming a plurality of electrode vias in a green sheet of a ceramic, and filling the electrode vias with an electrode paste from at least one face of the green sheet, to form a green sheet with electrodes;
a step of stacking and laminating a plurality of said green sheets with electrodes so that the respective electrodes are electrically, connected therebetween, thereby forming a laminated ceramic green sheet as an integral piece;
a step of firing the laminated ceramic green sheet to form a sintered ceramic body, the sintered ceramic body including internal electrodes to connect a top face and a bottom face, top face electrodes, and bottom face electrodes;
a step of obtaining a multilayer ceramic substrate by processing at least the top face of the sintered ceramic body, the multilayer ceramic substrate having a top face planarized so that, when zoned into a plurality of evaluation regions by the units of 20 mm x 20 mm, SFQR in a 20 mm x 20 mm evaluation region is equal to or less than 2 µ m in at least 50% of the plurality of evaluation regions; and
a step of forming a wiring pattern through photolithography using an exposure apparatus, the wiring pattern being electrically connected with the electrodes on at least the top face of the multilayer ceramic substrate.

23. The method of producing a wafer for mounting substrates of claim 22, wherein,
the step of forming the wiring pattern comprises:
a step of forming a dielectric layer at least on the top face, and forming at least one or more throughholes in a portion or portions of the dielectric layer for revealing an electrode or electrodes on the top face;
a step of forming a metal seed layer on the dielectric layer and in the throughhole;
a step of applying a photoresist on the metal seed layer;
a step of subjecting the photoresist to exposure by using an exposure apparatus;
a step of subjecting the photoresist having undergone exposure to development for partially removing the photoresist to obtain a photoresist pattern;
a step of allowing a plating layer to deposit on the metal seed layer, through an electroplating technique, in a place of the photoresist pattern where the photoresist has been partially removed, to obtain a wiring pattern;
a step of removing the photoresist pattern; and
a step of removing the metal seed layer formed in any region other than the place where the plating layer has been allowed to deposit.

24. The method of producing a wafer for mounting substrates of claim 22, wherein,
the step of forming the wiring pattern comprises:
a step of forming a dielectric layer at least on the top face, and forming at least one or more throughholes in a portion or portions of the dielectric layer for revealing an electrode or electrodes on the top face;
a step of applying a photoresist on the dielectric layer and over the throughhole;
a step of subjecting the photoresist to exposure by using an exposure apparatus;
a step of subjecting the photoresist having undergone exposure to development for partially removing the photoresist to obtain a photoresist pattern;
a step of forming a metal layer on the photoresist pattern, dielectric layer, and throughhole by a vacuum film deposition technique; and
a step of removing the photoresist pattern to remove (lift-off) the metal deposited on the photoresist pattern, thereby obtaining a wiring pattern while leaving only the metal deposited on the dielectric layer and the throughhole.

25. The method of producing a wafer for mounting substrates of any of claims 22 to 24, wherein, in the step of obtaining the multilayer ceramic substrate, a top-face ceramic layer and a bottom-face ceramic layer of the sintered ceramic body are subjected to a planarization process, one face at a time.

26. The method of producing a wafer for mounting substrates of any of claims 22 to 24, wherein, in the step of obtaining the multilayer ceramic substrate, a top-face ceramic layer and a bottom-face ceramic layer of the sintered ceramic body are subjected to a planarization process, both faces simultaneously.

27. The method of producing a wafer for mounting substrates of claim 25 or 26, wherein the step of obtaining the multilayer ceramic substrate comprises a step of processing at least a top face of the top-face ceramic layer by utilizing CMP (Chemical Mechanical Polishing).
